# EUROPEAN PATENT SPECIFICATION

(11) **EP 2 797 123 B1**
(45) Date of publication and mention of the grant of the patent: **18.03.2020**
(21) Application number: 14165208.1
(22) Date of filing: 17.04.2014
(51) Int. Cl.: H01L 31/167, H01L 31/02, H01L 25/16

(54) **Photosensor**
Fotosensor
Photodétecteur

(30) Priority: 24.04.2013 JP 2013091481
(43) Date of publication of application: 29.10.2014
(73) Proprietor: OMRON CORPORATION, Kyoto, Kyoto 600-8530 (JP)
(72) Inventor: Miyata, Tsuyoshi, Kyoto, Kyoto 600-8530 (JP); Nakajima, Jun, Kyoto, Kyoto 600-8530 (JP); Miyashita, Seiji, Kyoto, Kyoto 600-8530 (JP); Imai, Kiyoshi, Kyoto, Kyoto 600-8530 (JP); Ohtsuki, Kazuya, Kyoto, Kyoto 600-8530 (JP)
(74) Representative: Horn Kleimann Waitzhofer Patentanwälte PartG mbB

(56) References cited:
- JP-A- H11 121 807
- JP-A- H11 145 505
- JP-A- 2000 269 556
- US-A1- 2007 032 137
- US-B1- 7 575 482
- US-B1- 7 871 285

## Description

### Field of the Invention

The present invention relates to photosensors.

### Description of the Related Art

A photosensor is provided with a light emitting element, a light receiving element, and a seal part. For example, in the photosensor described in Japanese Unexamined Patent Publication No. 11-145505, the light emitting element and the light receiving element are connected via a lead frame, and one part of the lead frame is encapsulated in a seal part. Additionally, a connection terminal, which protrudes from the seal part, is also provided. A borehole through which the wire of a cable may be inserted is formed in the connection terminal; and the wire is secured to the connection terminal via soldering.

In the above described photosensor, a wire passes through the borehole of the connection terminal, and thereafter the connection terminal and the wire need to be soldered together. Therefore, there is the issue that there is an increase in the number of manufacturing workload.

Moreover, given that the connection terminal is integrated with the seal part, it is likely that heat will affect the seal part during soldering.

JP H11 121807 A discloses a LED lamp and a LED lamp assembly that allows to easily produce electrical connection and mechanical clamp without soldering. Further relevant prior art is disclosed in US 2007/032137 A1, US 7871285 B1, US 7575482 B1 and JP 2000269556 A.

### SUMMARY OF THE INVENTION

The present invention aims to provide a highly reliable photosensor that may be manufactured using a reduced number of manufacturing man-hours. The subject-matter of the present invention is defined in the claims.

A photosensor according to one aspect of the present invention comprises a sensor circuit assembly. The sensor circuit assembly includes a light emitting element, a light receiving element, a light-emitter support, a light-receiver support, and a connecting part. The light emitting element and the light receiving element face each other. The light-emitter support extends from the light emitting element and supports the light emitting element. The light-receiver support extends from the light receiving element and supports the light receiving element. The connecting part connects one end of the light-emitter support with one end of the light-receiver support. The connecting part includes a seal part and a first connection terminal that protrudes from the seal part. The first connection terminal includes a first press-contact part, and a first pressure part configured to press the first press-contact part in a press-contact direction.

In the photosensor, the light-emitter support and the light-receiver support respectively support the light emitting element and the light receiving element, and are connected by the connecting part which includes the seal part. Accordingly, the light emitting element, the light receiving element, and the seal part may be integrated within the sensor circuit assembly. Therefore, it is possible to install the light emitting element, the light receiving element, and the seal part, in a unified manner in another component. Additionally, the first connection terminal includes the first press-contact part, and therefore pressing the first connection terminal into contact with the wire connects the first connection terminal with the wire. Accordingly, there is no need for soldering when connecting the first connection terminal and the wire. Thus, the number of manufacturing man-hours decreases. Furthermore, given that soldering is no longer necessary, this curbs the effects of heat on the seal part. Thus, the reliability of the device improves. In this manner, a photosensor according to this aspect has increased reliability and uses a reduced number of manufacturing man-hours.

Moreover, the first connection terminal includes the first pressure part, and therefore the first connection terminal may be pressed into contact by pushing on the first pressure part. Accordingly, it is possible to reduce the load on the seal part compared to a case where the seal part needs to be pushed to make the press contact. Thus, the reliability of the device improves.

The first pressure part of the first connection terminal may be arranged outside a region on which the seal part projects in the press-contact direction. The seal part will not obstruct the first pressure part when the first pressure part is pressed. This facilitates press contact.

The first connection terminal further includes a joining part. The joining part joins the first press-contact part and the seal part. The width of the joining part is smaller than the width of the first press-contact part. The first connection terminal is shaped curving downward from the joining part. In this instance, the first connection terminal may be bent with little force compared to the case where the width of the joining part and the width of the first press-contact part are the same. Therefore it is possible to reduce the amount of force applied to the seal part when bending the first connection terminal. This prevents the seal part from breaking during the bending process. Additionally, given that the first connection terminal may be bent with a small amount of force, this improves the precision of the bending angle for the first connection terminal.

The first pressure part of the first connection terminal may be one portion of an edge face of the first connection terminal as a sheet thickness of the first connection terminal. This facilitates formation of the first pressure part.

The photosensor may further include a first wire configured to connect to the sensor circuit assembly. The first press-contact part of the first connection terminal is pressed into contact with the first wire in the press-contact direction.

The first wire may include a core, and an inner coating that covers the core. The first press-contact part of the first connection terminal passes through the inner coating and cuts into the first wire to come in contact with the core. In this case, pushing the connection terminals onto the wire facilitates pressing the terminals into contact with the wire without first having to remove the inner coating of the wire before press contact.

The photosensor further includes a holder that supports the first wire. The holder includes a first wire housing, and a first terminal housing. The first wire housing houses the first wire. The first terminal housing houses the first connection terminal. The first wire is pressed into contact with the first connection terminal within the first wire housing. When the photosensor includes the holder, pushing the first connection terminal relative to the first wire housing, thereby facilitates pressing the first connection terminal into contact with the first wire.

The first press-contact part of the first connection terminal includes a slit. During press contact, the core of the first wire enters the slit, and the first connection terminal and the wire are electrically connected.

The first terminal housing includes a protrusion. The protrusion protrudes from a bottom of the first wire housing toward the slit. The bottom of the first terminal housing faces a tip end of the first connection terminal when the first terminal housing houses the first connection terminal. During press contact, the protrusion pushes the core of the first wire into the slit of the first connection terminal. Therefore, this prevents the core from escaping from the slit during press contact. Hereby, an accurate connection between the core and the first connection terminal may be established.

The holder may further include a catch that locks onto the sensor circuit assembly. The catch locks onto the sensor circuit assembly when the first connection terminal is pressed into contact with the first wire. When the holder further includes a catch, and the catch of the holder locks onto the sensor circuit assembly to maintain firm press contact between the first connection terminal and the first wire. Furthermore, during press contact, the catch is in the locked position with the sensor circuit assembly when the first connection terminal is arranged in the press-contact position with the first wire. Therefore, a worker may use the catch locking onto the sensor circuit assembly as a means of easily determining whether press contact of the first connection terminal is complete.

A second wire may be further provided to connect to the sensor circuit assembly. The connecting part further includes a second connection terminal that protrudes from the seal part. The second connection terminal is pressed into contact with the second wire in the press-contact direction. When the second wire and second connection terminal is further provided, the plurality of connection terminals may be pressed into contact simultaneously. Thus, the number of manufacturing man-hours decreases.

The second connection terminal may include a second press-contact part, and a second pressure part configured to be used to press the second press-contact part in a press-contact direction. The second connection terminal may be pressed into contact by pushing on the second pressure part in this case. Accordingly, each of the connection terminals may be accurately pressed into contact, compared to providing a common pressure part configured to be used to press the first connection terminal into contact, and to press the second connection terminal into contact.

The seal part may include a first side, and a second side. The first side is located on the opposite side of the second side. The first connection terminal and the second connection terminal may be provided on the first side. That is, no connection terminals are provided on the second side. Providing the first and second connection terminals on the first side and no connection terminals on the second side facilitates uniformly pressing the plurality of connection terminals into contact, compared to a case where the connection terminals are provided on both the first side, and the second side.

A holder that supports the first wire and the second wire may be further provided. The holder includes a first wire housing, a second wire housing, a first terminal housing, and a second terminal housing. The first wire housing houses the first wire. The second wire housing houses the second wire. The first terminal housing houses the first connection terminal. The second terminal housing houses the second connection terminal. The first wire housing and the second wire housing are mutually partitioned. The first wire is pressed into contact with the first connection terminal within the first wire housing. The second wire is pressed into contact with the second connection terminal within the second wire housing. Therefore in this case, the first wire and the second wire may be prevented from coming into contact with each other because the first wire housing, and the second wire housing are mutually partitioned.

The photosensor may further include a cable and a holder that supports the cable. The cable includes a first wire, a second wire, and an outer coating. The outer coating covers the first wire and the second wire. The holder includes a borehole that passes through the holder. An inner surface of the borehole is provided with at least three protrusions. The cable is arranged to pass through the borehole. An adhesive fills between the inner surface of the borehole and the cable. The protrusions establish a uniform gap between the inner surface of the borehole and the outer surface of the cable. Therefore, a uniform amount of adhesive may be poured in between the borehole and the cable when bonding the cable to the borehole. This improves the strength of the adhesive bonding of the cable.

The protrusions may be arranged at equal intervals in the circumferential direction of the borehole. This further establishes a more precisely uniform gap between the inner surface of the borehole and the outer surface of the cable.

The borehole may include a first bore section and a second bore section. The first bore section and the second bore section are arranged side by side along the axial direction of the borehole. The second bore section includes an end section of the borehole. The inner diameter of the second bore section is larger than the inner diameter of the first bore section. Given that the second bore section including the end section of the borehole has a large inner diameter, this facilitates pouring the adhesive between the borehole and the cable.

The holder may include a positioning section. The positioning section is arranged to overlap with one portion of the borehole in the direction the borehole passes through the holder. Including a positioning section in the holder facilitates positioning the end section of the cable when the cable is inserted into the borehole.

The holder may include a wall. The wall is arranged to overlap with one portion of the borehole. The wall includes a first wire housing, and the second wire housing. The first wire housing houses the first wire. The second wire housing houses the second wire. The positioning section is a portion of the wall. The wall, provided with wire housings, may also serve as the positioning section in this case.

The sensor circuit assembly may include a light-emitter lens part and a light-receiver lens part. The light-emitter lens part covers the light emitting element. The light-receiver lens part covers the light receiving element. The light-receiver lens part and the light-emitter lens part have mutually different shapes. When the sensor circuit assembly includes a light-emitter lens part and a light-receiver lens part, the shape of the light-emitter lens part and the shape of the light-receiver lens part may be a shape that is appropriate for the light emitting element and the light receiving element respectively.

The photosensor may further include a cable, a holder, and a main case. The cable includes a first wire. The holder supports the sensor circuit assembly and the cable. The main case includes an internal space that houses the sensor circuit assembly and the holder. With the press-contact direction being downward, and the opposite being upward, the holder includes a borehole that passes vertically through the holder. The cable is arranged to pass through the borehole. The holder includes a first wire housing, and a first terminal housing. The first wire housing houses the first wire. The first terminal housing houses the first connection terminal. The first wire housing extends in a direction intersecting with the vertical direction and opens upward. The first terminal housing is arranged intersecting with the first wire housing, and opens upward. The sensor circuit assembly is mounted onto the holder from above. A tip end of the first connection terminal is arranged facing downward. The first press-contact part of the first connection terminal pierces the first wire from above in the first wire housing and is thereby pressed into contact with the first wire. The internal space of the main case is opens downward. The main case is mounted onto the holder from above.

When assembling the photosensor, in this instance, the cable is inserted vertically into the borehole. Additionally, the sensor circuit assembly is mounted onto the holder from above, and thereby the first connection terminal is inserted into the first terminal housing. Hereby the first connection terminal is pressed into contact with the first wire inside the first wire housing. The main case is then mounted onto the holder from above, and thereby the sensor circuit assembly and the holder are housed in the internal space of the main case. Thus, the sensor circuit assembly and the main case may be assembled onto the holder in this manner in order from the top. This facilitates the assembling of the photosensor.

The photosensor may further include a holder and a main case. The holder supports the sensor circuit assembly. The main case houses the sensor circuit assembly and the holder. A light-emitter case, a light-receiver case, and a detection groove are included in the main case. The light-emitter case houses the light emitting element. The light-receiver case houses the light receiving element. The detection groove is located between the light-emitter case and the light-receiver case. The main case includes a mark. The mark indicates the detection depth required for an object to be detected in the detection groove. When there is a mark indicating the required detection depth, an operator may use the mark to easily determine the detection depth. Moreover, the detection depth signifies that stable detection will take place when an object to be detected is inserted at that depth or deeper than that depth.

The photosensor may further include a cable, a holder, and a main case. The cable includes a first wire and a second wire. The holder supports the sensor circuit assembly and the cable. The main case includes an internal space that houses the sensor circuit assembly and the holder. With the press-contact direction being downward, and the opposite being upward, the holder includes a borehole that passes vertically through the holder. The cable is arranged to pass through the borehole. The holder includes a first wire housing, a second wire housing, a first terminal housing, and a second terminal housing. The first wire housing houses the first wire. The second wire housing houses the second wire. The first terminal housing houses the first connection terminal. The second terminal housing houses the second connection terminal. The first wire housing and the second wire housing extend in a direction intersecting the vertical direction and open upward. The first terminal housing is arranged intersecting with the first wire housing, and opens upward. The second terminal housing is arranged intersecting with the second wire housing, and opens upward. A tip end of the first connection terminal and the tip end of the second connection terminal are arranged facing downward. The first connection terminal is pressed into contact with the first wire within the first wire housing. The second connection terminal is pressed into contact with the second wire within the second wire housing.

In this case the sensor circuit assembly is mounted onto the holder from above, and thereby the first connection terminal is inserted into the first terminal housing, and the second connection terminal is inserted into the second terminal housing. Hereby the first connection terminal is pressed into contact with the first wire inside the first wire housing, and the second connection terminal is pressed into contact with the second wire inside the second wire housing. When the sensor circuit assembly is mounted onto the holder in this manner, the first connection terminal is pressed into contact at the same time the second connection terminal is pressed into contact. This facilitates the assembling of the photosensor.

### BRIEF DESCRIPTION OF THE DRAWINGS

- FIG. 1: is a perspective view of a photosensor.
- FIG. 2: is an exploded perspective view of the photosensor.
- FIG. 3: is a perspective view of the sensor body.
- FIG. 4: is a front view of the sensor body.
- FIG. 5: is a side view of the sensor body.
- FIG. 6: is an enlarged view of a first connection terminal.
- FIG. 7: is a perspective view of a holder.
- FIG. 8: is a perspective view illustrating the holder, the sensor body, and the cable.
- FIG. 9: is a top view of the holder.
- FIG. 10: is a front view of the holder.
- FIG. 11: is an enlarged view of a first wire holder.
- FIG. 12: is a side view of the holder.
- FIG. 13: is a cross-sectional view along XIII-XIII in FIG. 12.
- FIG. 14: is an enlarged view of the first connection terminal and the first terminal housing.
- FIG. 15: is a cross-sectional view along XV-XV in FIG. 9.
- FIG. 16: is a bottom view of the holder.
- FIG. 17: is a perspective view of the main case.
- FIG. 18: is a perspective view of the sub case.
- FIG. 19: illustrates a process for manufacturing the sensor body.
- FIG. 20: illustrates an assembly process for the photosensor.
- FIG. 21: illustrates an assembly process for the photosensor.
- FIG. 22: illustrates an assembly process for the photosensor.
- FIG. 23: illustrates a connection terminal not being part of the invention.

FIG. 24 illustrates a light-emitter lens part and a light-receiver lens part in accordance with another embodiment.

FIG. 25 illustrates a detection depth mark in accordance with another embodiment.

### DETAILED DESCRIPTION OF THE PREFERRED EMBODIMENTS

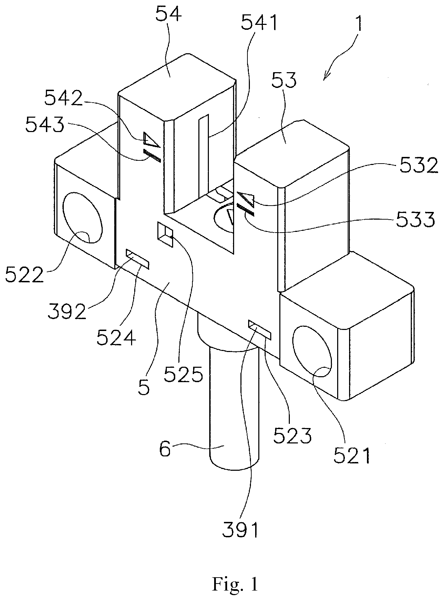

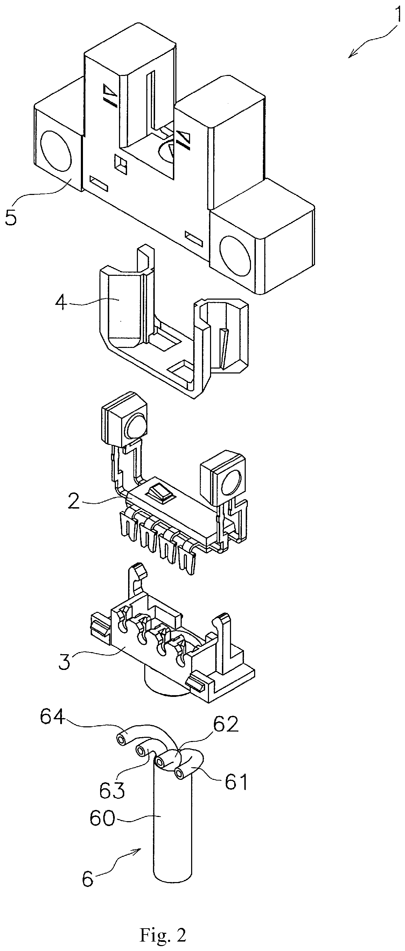

A photosensor 1 according to an embodiment of the present invention will be described below with reference to the drawings. FIG. 1 is a perspective view of the photosensor 1. FIG. 2 is an exploded perspective view of the photosensor 1. As illustrated in FIG. 2 the photosensor 1 includes a sensor circuit assembly 2, a holder 3, a sub case 4, a main case 5, and a cable 6.

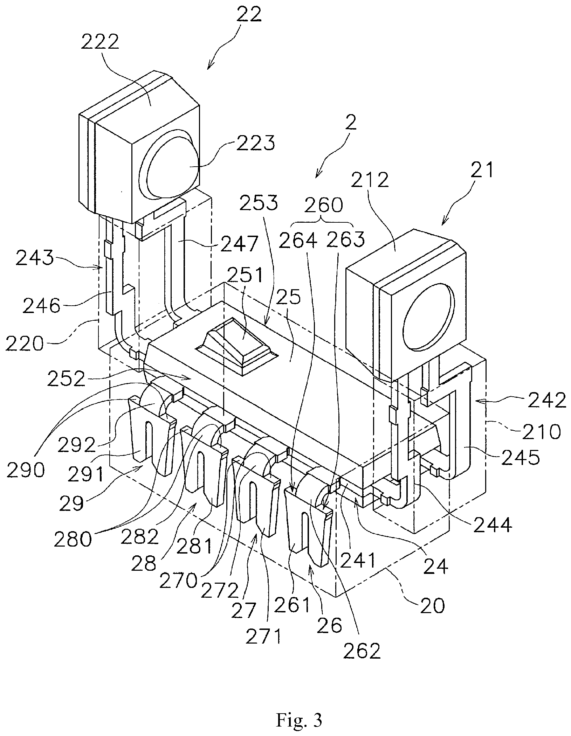

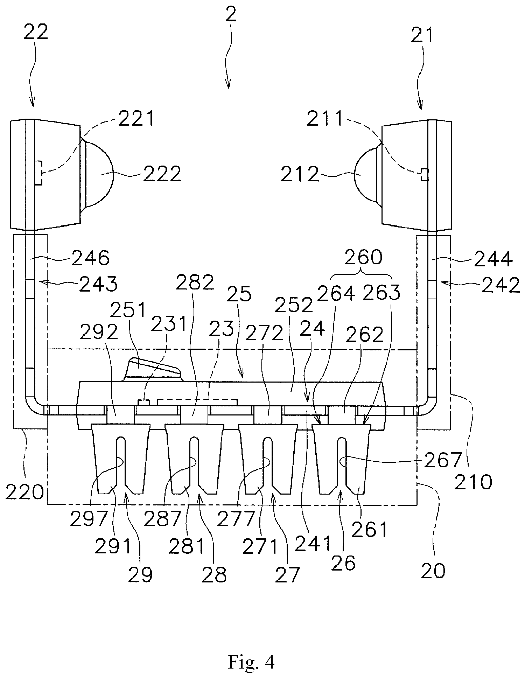

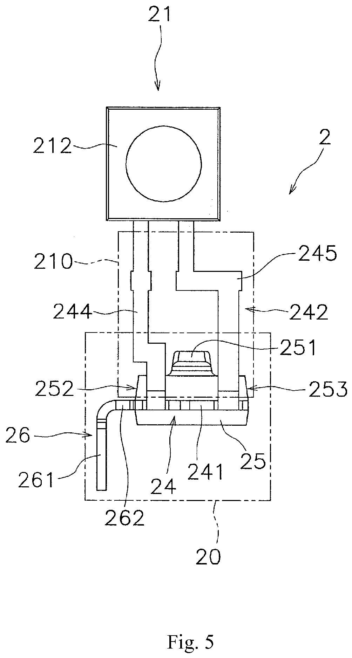

FIG. 3 is a perspective view of the sensor circuit assembly 2. FIG. 4 is a front view of the sensor circuit assembly 2. FIG. 5 is a side view of the sensor circuit assembly 2.

As illustrated in FIG. 3 to FIG. 5 the sensor circuit assembly 2 includes a light emitter part 21, a light receiver part 22, and a connecting part 20. The light emitter part 21, the light receiver part 22, and the connecting part 20 are all integrated.

In the present embodiment, a press-contact direction (later described) is referred to as "downward". The direction opposite the press-contact direction is referred to as "upward". The direction intersecting the press-contact direction, which is the direction along which the light emitter part 21 and light receiver part 22 are lined up, is referred to as the "left and right direction". The direction in which the light emitter part 21 and the light receiver part 22 are lined up, and which intersects with the press-contact direction is referred to as "front and rear direction".

As illustrated in FIG. 4 the light emitter part 21 includes a light emitting element 211, a light-emitter lens part 212, and a light-emitter support 210. The light emitting element 211 may be, for example, a light emitting diode. However, a different element besides a light emitting diode may be used as the light emitting element 211. The light emitting element 211 is mounted on a lead frame 24 (later described). The light-emitter lens part 212 covers the light emitting element 211. The light-emitter lens part 212 is circular when viewed from the light emission direction. The light-emitter lens part 212 may be formed from a translucent material. The light-emitter lens part 212 may be made from resin, for example. The light-emitter support 210 supports the light emitting element 211. The light-emitter support 210 extends upward from the connecting part 20. The light-emitter support 210 includes light-emitter leads 242.

The light receiver part 22 is arranged separate from the light emitter part 21 in the left and right direction. The light receiver part 22 includes a light receiving element 221, a light-receiver lens part 222, and a light-receiver support 220. The light receiving element 221 may be, for example, a phototransistor. However, a different element besides a phototransistor may be used as the light receiving element 221. The light receiving element 221 is mounted on the lead frame 24. The light receiving element 221, and the light emitting element 211 are arranged facing each other. In other words, the photosensor 1 according to the present embodiment is a so-called transmissive photosensor. The light-receiver support 220 supports the light receiving element 221. The light-receiver support 220 extends upward from the connecting part 20. The light-receiver support 220 includes light-receiver leads 243.

The light-receiver lens part 222 covers the light receiving element 221. The light-receiver lens part 222 is circular when viewed from the light receiving direction. The light-receiver lens part 222 and the light-emitter lens part 212 are arranged facing each other. The shape of the light-receiver lens part 222 differs from the shape of the light-emitter lens part 212. More specifically, the area of the light-receiver lens part 222 differs from the area of the light-emitter lens part 212. In other words, the diameter of the light-receiver lens part 222 differs from the diameter of the light-emitter lens part 212. The diameter of the light-receiver lens part 222 is larger than the diameter of the light-emitter lens part 212. The light-receiver lens part 222 may be formed from a translucent material. The light-receiver lens part 222 may be made from resin, for example. The light-receiver lens part 222 may be made from the same material as the light-emitter lens part 212.

The connecting part 20 connects one end of the light-emitter support 210 with one end of the light-receiver support 220. The connecting part 20 includes a circuit 23, a seal part 25, main leads 241, and a plurality of connection terminals 26-29.

The circuit 23 is electrically connected to the light emitting element 211, and the light receiving element 221 via the lead frame 24. The circuit 23 is an electronic circuit that controls the light receiving element 221 and the light emitting element 211. The circuit 23 is mounted on the lead frame 24. For example, the circuit 23 may be mounted to the lead frame 24 via a mounting method such as wire bonding. The circuit 23 includes, for example, an IC chip. The circuit 23 controls the emission of light from the light emitting element 211. The circuit 23 also determines whether or not light is received at the light receiving element 221, and controls the output signal on the basis of the determined result. The sensor circuit assembly 2 includes an operation indicator 231. The circuit 23 controls the operation indicator 231 on the basis of the result of determining whether or not light was received. The operation indicator 231 is, for example, a light emitting element such as a light emitting diode, and is mounted on the lead frame 24.

The lead frame 24 includes the above described main leads 241, the light-emitter leads 242, and the light-receiver leads 243. The main leads 241 are flat in directions extending parallel to the left and right direction and the front and rear direction. The main leads 241 are located between the light-emitter leads 242 and the light-receiver leads 243 in the left and right direction. The above described circuit 23 is mounted on the main leads 241. The above described operation indicator 231 is also mounted on the main leads 241.

The light-emitter leads 242 connect the light emitting element 211 and the main leads 241. The light emitting element 211 is mounted on the light-emitter leads 242. The light-emitter leads 242 protrude rightward out from the main leads 241. The light-emitter leads 242 are shaped curving upward. As illustrated in FIG. 3, the light-emitter leads 242 include a first light-emitter lead 244 and a second light-emitter lead 245. The first light-emitter lead 244 and the second light-emitter lead 245 are arranged separated from each other in the front and rear direction. The first light-emitter lead 244 and the second light-emitter lead 245 have mutually different shapes.

The light-receiver leads 243 connect the light receiving element 221 and the main leads 241. The light receiving element 221 is mounted on the light-receiver leads 243. The light-receiver leads 243 mirrors the shape of the light-emitter leads 242 with respect to a plane that is perpendicular to the left and right direction. The light-receiver leads 243 protrude leftward out from the main leads 241. The light-receiver leads 243 are shaped curving upward. The light-receiver leads 243 include a first light-receiver lead 246, and a second light-receiver lead 247. The first light-receiver lead 246 and the second light-receiver lead 247 are arranged separated from each other in the front and rear direction. The first light-receiver lead 246 and the second light-receiver lead 247 have mutually different shapes. The first light-emitter lead 244 and the first light-receiver lead 246 mirror each other with respect to a plane perpendicular to the left and right direction. The second light-emitter lead 245 and the second light-receiver lead 247 mirror each other with respect to a plane perpendicular to the left and right direction.

The seal part 25 seals the circuit 23 on the lead frame 24. The seal part 25 seals the circuit 23 and one portion of the lead frame 24. More specifically, the seal part 25 seals the circuit 23 on the main leads 241. The seal part 25 also seals the operation indicator 231 on the main leads 241. The seal part 25 may be formed from a translucent material. The seal part 25 may be made from resin, for example. The seal part 25 has a projection 251 that protrudes upward. The projection 251 is arranged facing the operation indicator 231. The seal part 25 may be made from the same material as the light-emitter lens part 212 and the light-receiver lens part 222.

The plurality of connection terminals 26-29, protruding from the seal part 25, is arranged horizontally side by side. The seal part 25 includes a first side 252 and a second side 253. The first side 252 is the front surface of the seal part 25. The second side 253 is located on the opposite side of the first side 252. In other words, the second side 253 is the rear surface of the seal part 25. Of the first side 252 and the second side 253, the plurality of connection terminals 26-29 is provided on only the first side 252. That is, no connection terminals are provided on the second side 253. The tip ends of the plurality of connection terminals 26-29 are arranged facing downward. As will be later described, the plurality of connection terminals 26-29 is respectively pressed into contact with a plurality of wires 61-64.

The plurality of connection terminals 26-29 includes a first connection terminal 26, a second connection terminal 27, a third connection terminal 28, and a fourth connection terminal 29. The first connection terminal 26 and the fourth connection terminal 29 are arranged separated from each other in the left and right direction. The second connection terminal 27 and the third connection terminal 28 are arranged between the first connection terminal 26 and the fourth connection terminal 29. The first connection terminal 26 and the fourth connection terminal 29 are power supply terminals for supplying the circuit 23 with power. The second connection terminal 27 and the third connection terminal 28 are output terminals for outputting the output signal from the circuit 23.

The first connection terminal 26 includes a first press-contact part 261 and a first joining part 262. The first joining part 262 joins the first press-contact part 261 and the seal part 25. The first joining part 262 is integrally connected with the lead frame 24. The width of the first joining part 262 is smaller than the width of the first press-contact part 261. The first connection terminal 26 is shaped bending downward from the first joining part 262.

As illustrated in FIG. 3 and FIG. 4, the first connection terminal 26 includes a first pressure part 260. The first pressure part 260 is a portion for pressing the first press-contact part 261 in the press-contact direction. That is, the first pressure part 260 is for pressing the first press-contact part 261 downward. The first pressure part 260 is one portion of the edge face (the face formed from the thickness of a sheet like member) of the first connection terminal as a sheet thickness of the first connection terminal 26. The first pressure part 260 is arranged outside a region on which the seal part 25 projects in the press-contact direction. In other words, the first pressure part 260 does not overlap the seal part 25 when viewed from the press-contact direction. The first pressure part 260 includes a first tiered-part 263 and a second tiered-part 264. The first tiered-part 263 and the second tiered-part 264 are arranged contiguously with the first joining part 262. The first joining part 262 is connected with the first press-contact part 261 between the first tiered-part 263 and the second tiered-part 264. The first tiered-part 263 and the second tiered-part 264 are flat shapes that extend in the left and right direction.

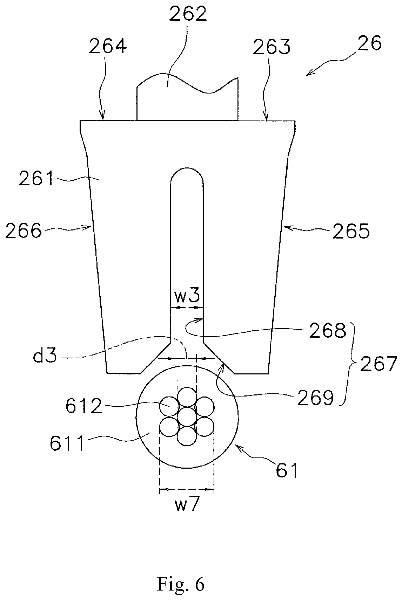

FIG. 6 is an enlarged view of the first press-contact part 261. The first press-contact part 261 tapers downward. More specifically, the first press-contact part 261 includes a first-side end part 265 and a second-side end part 266. The first-side end part 265 is the right-side end of the first press-contact part 261. The second-side end part 266 is located on the opposite side of the first-side end part 265. In other words, the second-side end part 266 is the left-side end of the first press-contact part 261. The distance between the first-side end part 265 and the second-side end part 266 decreases toward the lower portion of the first-side end part 265 and the second-side end part 266.

The tip end of the first connection terminal 26 includes a slit 267. That is, the first press-contact part 261 includes the slit 267. The slit 267 extends from the tip end toward the upper portion of the first connection terminal 26. The slit 267 includes a linear part 268 and an expanded part 269. The expanded part 269 is located below the linear part 268. The expanded part 269 is provided at the entrance to the slit 267. The width of the slit 267 widens toward the lower portion of the expanded part 269. The linear part 268 has a linear shape and extends upward from the expanded part 269.

The second connection terminal 27, the third connection terminal 28, and the fourth connection terminal 29 are all structured in the same manner as the first connection terminal 26. More specifically, the second connection terminal 27 includes a second press-contact part 271 and a second joining part 272. The third connection terminal 28 includes a third press-contact part 281 and a third joining part 282. The fourth connection terminal 29 includes a fourth press-contact part 291 and a fourth joining part 292. The second press-contact part 271, the third press-contact part 281, and the fourth press-contact part 291 are all structured in the same manner as the first press-contact part 261, therefore a description thereof will be omitted. The second joining part 272, the third joining part 282, and the fourth joining part 292 are all structured in the same manner as the first joining part 262, therefore a description thereof will be omitted. Additionally, as illustrated in FIG. 3, the second connection terminal 27 includes a second pressure part 270. The third connection terminal 28 includes a third pressure part 280. The fourth connection terminal 29 includes a fourth pressure part 290. The second pressure part 270, the third pressure part 280, and the fourth pressure part 290 are all structured in the same manner as the first pressure part 260, therefore a description thereof will be omitted.

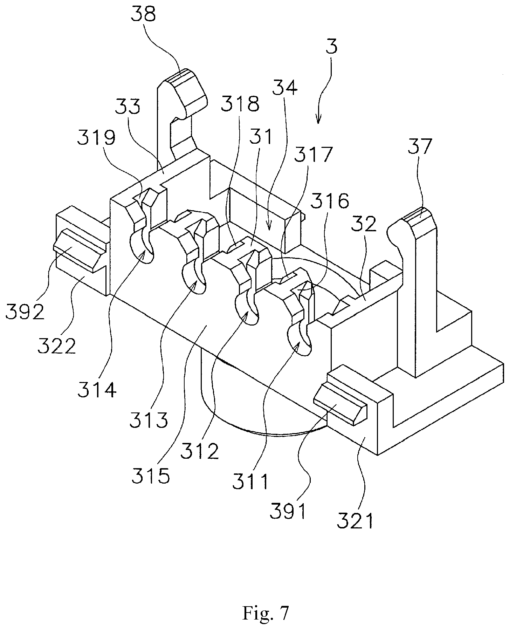

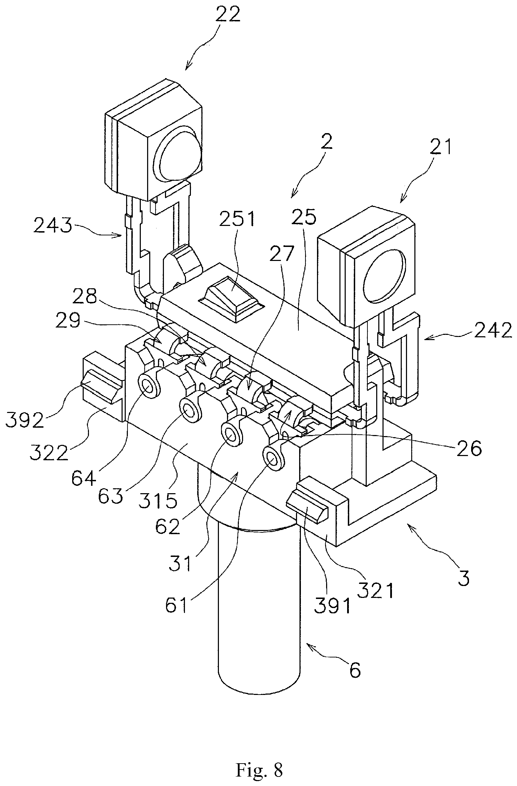

FIG. 7 is a perspective view of the holder 3. FIG. 8 is a perspective view illustrating the holder 3, the sensor circuit assembly 2, and the cable 6. As illustrated in FIG. 8, the cable 6 includes a plurality of wires 61-64. More specifically, the cable 6 includes a first wire 61, a second wire 62, a third wire 63, and a fourth wire 64. The holder 3 supports the sensor circuit assembly 2 and the plurality of wires 61-64.

The holder 3 includes a first wall 31. As illustrated in FIG. 7 the first wall 31 includes a plurality of wire housings 311-314. The plurality of wire housings 311-314 respectively houses the plurality of wires 61-64. The plurality of wire housings 311-314 passes through the first wall 31 in the front and rear direction. The plurality of wire housings 311-314 opens upward.

As illustrated in FIG. 2, the cable 6 includes an outer coating 60. The outer coating 60 covers the plurality of wires 61-64. The outer coating 60 is removed from the end part of the cable 6, exposing the plurality of wires 61-64. The plurality of wire housings 311-314 supports the plurality of wires 61-64 exposed from the outer coating 60.

As illustrated in FIG. 7, the first wall 31 includes a first wire housing 311, a second wire housing 312, a third wire housing 313, and a fourth wire housing 314. The first to fourth wire housings 311-314 are mutually partitioned and arranged in the left and right direction side by side. The first wire housing 311 houses the first wire 61. The second wire housing 312 houses the second wire 62. The third wire housing 313 houses the third wire 63. The fourth wire housing 314 houses the fourth wire 64.

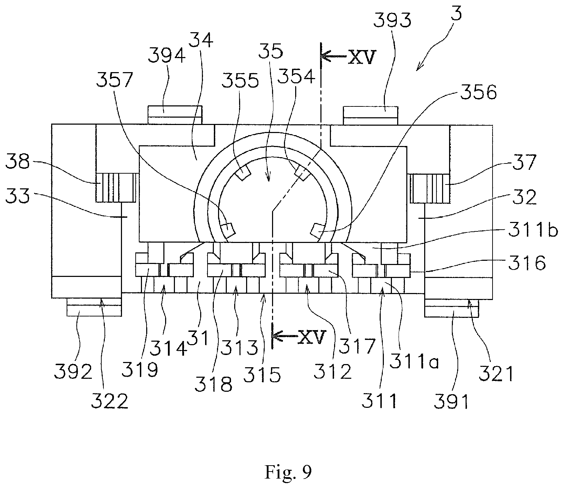

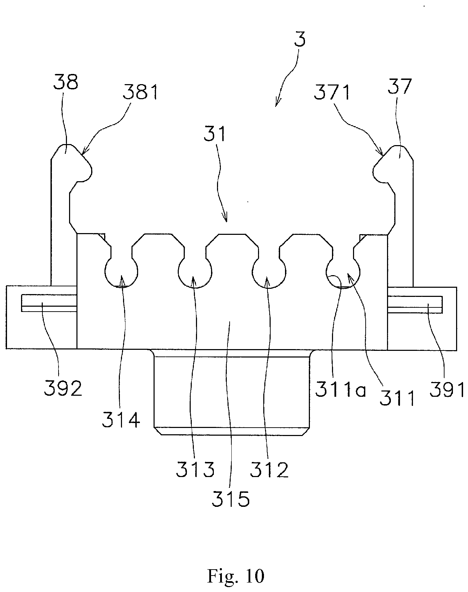

FIG. 9 is a top view of the holder 3. As illustrated in FIG. 9, the first wire housing 311 extends longitudinally. The first wire housing 311 reaches a front end surface 315 of the first wall 31. FIG. 10 is a front view of the holder 3. As illustrated in FIG. 7 and FIG. 10, the first wire housing 311 opens upward.

As illustrated in FIG. 7 and FIG. 9, the first wall 31 includes a plurality of terminal housings 316-319. The plurality of terminal housings 316-319 respectively houses the plurality of connection terminals 26-29. More specifically, the first wall 31 includes a first terminal housing 316, a second terminal housing 317, a third terminal housing 318, and a fourth terminal housing 319. The first to fourth terminal housings 316-319 are mutually partitioned and arranged horizontally side by side. The first terminal housing 316 is arranged intersecting with the first wire housing 311. The first terminal housing 316 houses the first connection terminal 26. The second terminal housing 317 is arranged intersecting with the second wire housing 312. The second terminal housing 317 houses the second connection terminal 27. The third terminal housing 318 is arranged intersecting with the third wire housing 313. The third terminal housing 318 houses the third connection terminal 28. The fourth terminal housing 319 is arranged intersecting with the fourth wire housing 314. The fourth terminal housing 319 houses the fourth connection terminal 29.

The first wire housing 311 includes a first wire holder 311a and a first wire guide part 311b. The first wire holder 311a is located in front of the first terminal housing 316. The first wire guide part 311b is located behind the first terminal housing 316.

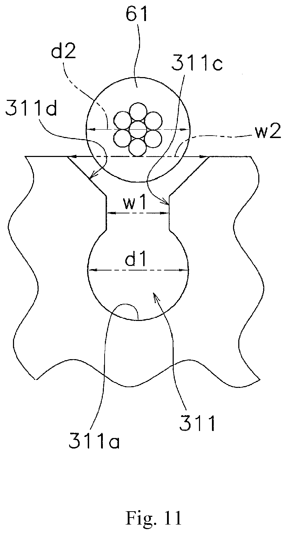

FIG. 11 is an enlarged view of the first wire holder 311a. Additionally, FIG. 11 shows a cross-section of the first wire holder 311a and the wire 61. As illustrated in FIG. 11, the diameter d1 of the first wire holder 311a is the same as, or smaller than the diameter d2 of the wire 61. The wire 61 is thereby supported inside the first wire holder 311a and does not move.

Further, as illustrated in FIG. 11, the first wire housing 311 includes a first slot 311c. The first slot 311c is located in a first wire holder 311a for inserting the wire 61. The width w1 of the first slot 311c is smaller than the diameter d2 of the wire 61. Additionally, the width w1 of the first slot 311c is smaller than the diameter d1 of the first wire holder 311a.

The first wire housing 311 includes an expanded slot 311d. The expanded slot 311d is located above the first slot 311c. The width of the expanded slot 311d increases toward the upper portion thereof. The width w2 of the upper end part of the expanded slot 311d is larger than the diameter d2 of the wire 61. This facilitates insertion of the wire 61 into the first slot 311c. The second to fourth wire housings 312 - 314 are configured in the same manner as the first wire housing 311, therefore the description thereof will be omitted.

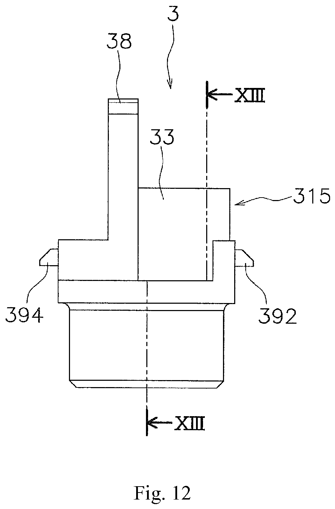

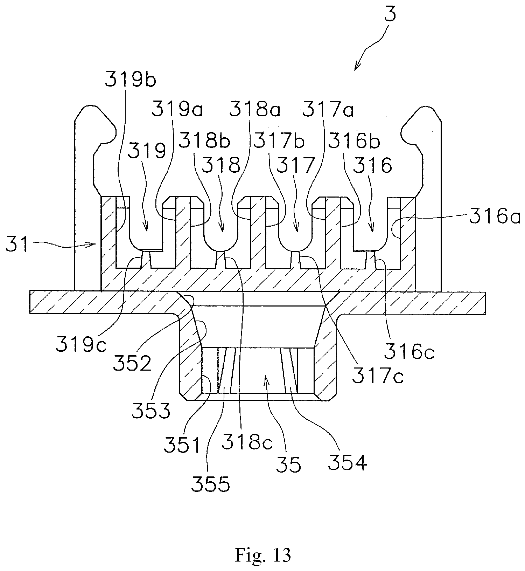

FIG. 12 is a side view of the holder 3. FIG. 13 is a cross-sectional view along XIII-XIII in FIG. 12. As illustrated in FIG. 7 and FIG. 13, the first terminal housing 316 opens upward. As illustrated in FIG. 13, the first terminal housing 316 includes a pair of first wall surfaces 316a, 316b. The pair of first wall surfaces 316a, 316b are arranged horizontally side by side. The first connection terminal 26 is arranged between the pair of first wall surfaces 316a, 316b. The second terminal housing 317 includes a pair of second wall surfaces 317a, 317b. The pair of second wall surfaces 317a, 317b are arranged horizontally side by side. The second connection terminal 27 is arranged between the pair of second wall surfaces 317a, 317b. The third terminal housing 318 includes a pair of third wall surfaces 318a, 318b. The pair of third wall surfaces 318a, 318b are arranged horizontally side by side. The third connection terminal 28 is arranged between the pair of third wall surfaces 318a, 318b. The fourth terminal housing 319 includes a pair of fourth wall surfaces 319a, 319b. The pair of fourth wall surfaces 319a, 319b are arranged horizontally side by side. The fourth connection terminal 29 is arranged between the pair of fourth wall surfaces 319a, 319b.

As illustrated in FIG. 13, the first wall 31 includes a plurality of protrusions 316c, 317c, 318c, 319c. The protrusions 316c, 317c, 318c, 319c are provided at the respective bottoms of the plurality of terminal housings 316-319. The bottom of each of the terminal housings 316-319 faces the tip end of each of the connection terminals 26-29 when the terminal housings 316-319 house the connection terminals 26-29. More specifically, the first wall 31 includes a first protrusion 316c, a second protrusion 317c, a third protrusion 318c, and a fourth protrusion 319c. The first protrusion 316c protrudes from the bottom of the first terminal housing 316 toward the slit 267 (refer to FIG. 4) in the first connection terminal 26. The second protrusion 317c protrudes from the bottom of the second terminal housing 317 toward a slit 277 (refer to FIG. 4) in the second connection terminal 27. The third protrusion 318c protrudes from the bottom of the third terminal housing 318 toward a slit 287 (refer to FIG. 4) in the third connection terminal 28. The fourth protrusion 319c protrudes from the bottom of the fourth terminal housing 319 toward a slit 297 (refer to FIG. 4) in the fourth connection terminal 29.

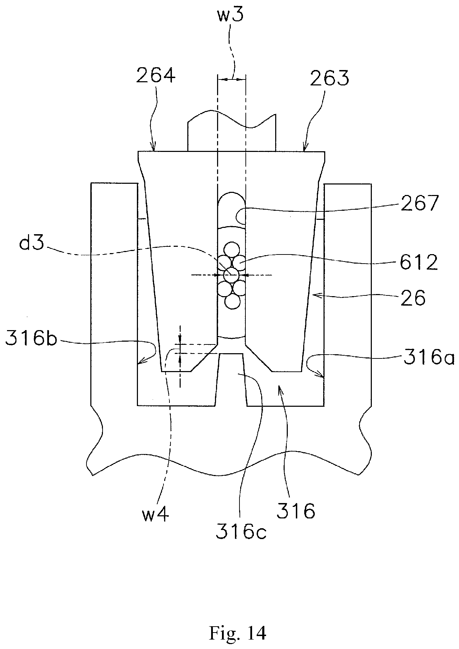

FIG. 14 is an enlarged view of the first connection terminal 26 and the first terminal housing 316. FIG. 14 illustrates the first connection terminal 26 and the first terminal housing 316 when the first to fourth connection terminals 26-29 are arranged in a press-contact position with the wires 61-64. As illustrated in FIG. 6, the first connection terminal 26, oriented downward, pierces the wire 61 and is thereby pressed into contact with the wire 61. The first connection terminal 26 pierces the wire 61 such that the first connection terminal 26 passes through an inner coating 611 of the wire 61 and comes in contact with the core 612. Hereby, as illustrated in FIG. 14, the core 612 is sandwiched in the first connection terminal 26 inside the slit 267, and the first connection terminal 26 is thus connected to the wire 61.

As illustrated in FIG. 6, the width w3 of the slit 267 in the first connection terminal 26 is larger than the diameter d3 of the core 612. Additionally, the width w3 of the slit 267 in the first connection terminal 26 is smaller than the width w7 of a bundle of a plurality of cores 612 that are not in press contact. Accordingly, during press contact, as illustrated in FIG. 14, the deformation of a bundle of the cores 612 thereby allows the bundle of the cores 612 to be inserted into the slit 267 in the first connection terminal 26. Finally, in FIG. 6 and FIG. 14 only one portion of the plurality of cores 612 is given the reference sign 612.

When the first to fourth connection terminals 26-29 are arranged in the press-contact position with the wires 61-64, a gap is created between the first protrusion 316c and the first connection terminal 26 without the first protrusion 316c coming into contact with the first connection terminal 26. Hereby, it is possible for the inner coating 611 of the wire 61 to pass through the gap and escape from the slit 267 when the first connection terminal 26 is pressed into contact with the wire 61. The distance w4 between the first protrusion 316c and the first connection terminal 26 is smaller than the diameter d3 of the core 612 in the wire 61. Furthermore, the first tiered-part 263 and the second tiered-part 264 of the first connection terminal 26 protrude upward from the first terminal housing 316 when the first to fourth connection terminals 26-29 are arranged in the press-contact position with the wires 61-64.

As illustrated in FIG. 7 and FIG. 9, the holder 3 includes a second wall 32 and a third wall 33. The second wall 32 and the third wall 33 are arranged separated from each other in the left and right direction. The second wall 32 connects to the right end part of the first wall 31. The third wall 33 connects to the left end part of the first wall 31. The upper surfaces of the first wall 31, the second wall 32, and the third wall 33 are all positioned at the same height. The upper surfaces of the first wall 31, the second wall 32, and the third wall 33 are in contact with the bottom surface of the sensor circuit assembly 2, and support the sensor circuit assembly 2.

As illustrated in FIG. 7 and FIG. 8, the holder 3 includes a first catch 37 and a second catch 38, which lock onto the sensor circuit assembly 2. The first catch 37 and the second catch 38 are arranged separated from each other in the left and right direction. The first catch 37 and the second catch 38 extend to a position above the above described first wall 31, the second wall 32, and the third wall 33. The tip end parts of the first catch 37 and the second catch 38 are shaped to protrude toward each other. More specifically, the tip end part of the first catch 37 protrudes leftward. The tip end part of the second catch 38 protrudes rightward. Furthermore, the tip end part of the first catch 37 and the tip end part of the second catch 38 will be caught on the upper surface of the seal part 25 when the sensor circuit assembly 2 is placed between the first catch 37 and the second catch 38. The sensor circuit assembly 2 may thus be secured to the holder 3.

As illustrated in FIG. 10, the tip end part of the first catch 37 includes a first inclined surface 371. The tip end part of the second catch 38 includes a second inclined surface 381. The first inclined surface 371 and the second inclined surface 381 are inclined so that the mutual distance therebetween widens toward the respective upper portions. Accordingly, pushing the sensor circuit assembly 2 downward toward the first catch 37 and the second catch 38 thus widens the gap between the first catch 37 and the second catch 38, and thereby facilitates arranging the sensor circuit assembly 2 between the first catch 37 and the second catch 38. Furthermore, the first catch 37 and the second catch 38 arrive at the locked position with the sensor circuit assembly 2 when the above described first to fourth connection terminals 26-29 are arranged in the press-contact position with the wires 61-64. Finally, as illustrated in FIG. 8, the bottom of the sensor circuit assembly 2 is supported by the upper surfaces of the first wall 31, the second wall 32, and the third wall 33 when the first to fourth connection terminals 26-29 are arranged in the press-contact position with the wires 61-64.

As illustrated in FIG. 7 and FIG. 9, the holder 3 includes a recess 34. The recess 34 is located between the second wall 32 and the third wall 33 in the left and right direction. The recess 34 is located behind the first wall 31.

As illustrated in FIG. 9 and FIG. 13, the holder 3 includes a borehole 35. The borehole 35 passes vertically through the holder 3. The borehole 35 is provided in the recess 34. As illustrated in FIG. 13, the borehole 35 includes a first bore section 351, a second bore section 352, and a third bore section 353. The first bore section 351, the second bore section 352, and the third bore section 353 are arranged side by side along the axial direction of the borehole 35. In other words, the first bore section 351, the second bore section 352, and the third bore section 353 are arranged vertically side by side.

The first bore section 351 is linear and extends vertically. The inner diameter of the first bore section 351 is larger than the outer diameter of the cable 6. The second bore section 352 includes the upper end section of the borehole 35. In other words, the second bore section 352 connects to the bottom of the recess 34. The inner diameter of the second bore section 352 is larger than the inner diameter of the first bore section 351. More specifically, the inner diameter of the second bore section 352 is larger toward the upper portion thereof. The third bore section 353 is located between the first bore section 351 and the second bore section 352. The inner diameter of the third bore section 353 is larger toward the upper portion thereof. The inner diameter of the third bore section 353 is larger than the inner diameter of the first bore section 351 and smaller than the inner diameter of the second bore section 352.

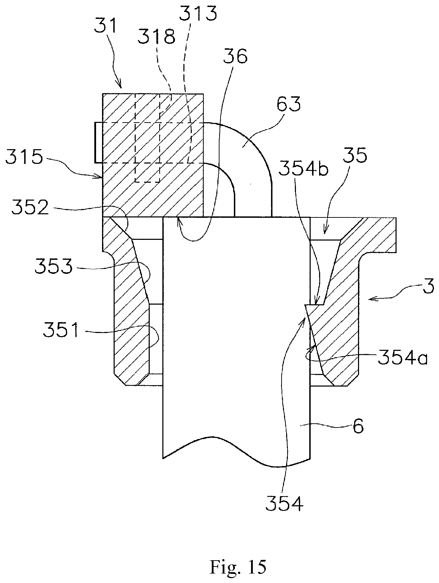

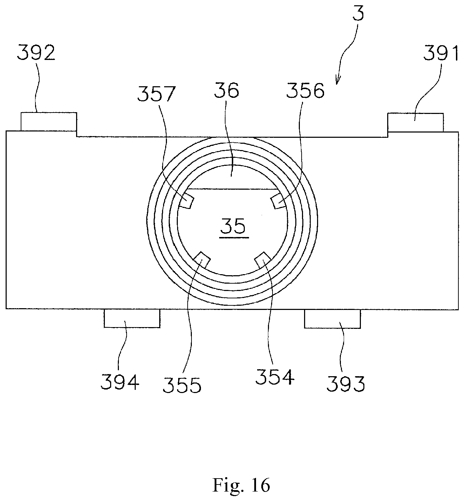

FIG. 15 is a cross-sectional view along XV-XV in FIG. 9. FIG. 16 is a bottom view of the holder 3. FIG. 15 schematically illustrates the cable 6 inserted into the borehole 35. As illustrated in FIG. 15 and FIG. 16, the holder 3 includes a positioning section 36. The positioning section 36 is arranged to overlap with one portion of the borehole 35 at the upper portion of the borehole 35. The positioning section 36 is the bottom surface of the first wall 31.

As illustrated in FIG. 9 and FIG. 13, the inner surface of the borehole 35 includes a plurality of protrusions 354-357. The plurality of protrusions 354-357 protrudes from the inner surface of the borehole 35 toward the central axis of the borehole 35. The plurality of protrusions 354-357 is arranged at equal intervals in the inner circumferential direction of the borehole 35. The diameter of a circle passing through the tip ends of the plurality of protrusions 354-357 is smaller than the outer diameter of the cable 6. Additionally, the protrusions 354-357 taper toward the central axis of the borehole 35. Therefore, as illustrated in FIG. 15, when the cable 6 is inserted into the borehole 35, the tip ends of the protrusions 354-357 eat into the outer surface of the cable 6. This prevents the cable 6 from slipping out. More specifically, the inner surface of the borehole 35 includes a first protrusion 354, a second protrusion 355, a third protrusion 355, and a fourth protrusion 357. As illustrated in FIG. 15, the first protrusion 354 includes an inclined surface 354a and a catch surface 354b. The inclined surface 354a is inclined in relation to the axial direction of the borehole 35. The inclined surface 354a is inclined so that the upper portion of the inclined surface approaches the central axis of the borehole 35. The catch surface 354b protrudes from the inner surface of the borehole 35 toward the central axis of the borehole 35, and catches the outer surface of the cable 6. The second to fourth protrusions 355-357 are configured in the same manner as the first protrusion 354; therefore the description thereof will be omitted. The above-mentioned kind of shape of the plurality of protrusions 354-357 facilitates the insertion of the cable 6 upward into the borehole 35 while restricting the downward movement of the cable 6 in the borehole 35.

As above described, the inner diameter of the borehole 35 is larger than the outer diameter of the cable 6. Additionally the plurality of protrusions 354-357 supports the cable 6, resulting in a gap between the cable 6 and the borehole 35. An adhesive may be poured into this gap, and the cable 6 may be bonded to the inner surface of the borehole 35 with the adhesive.

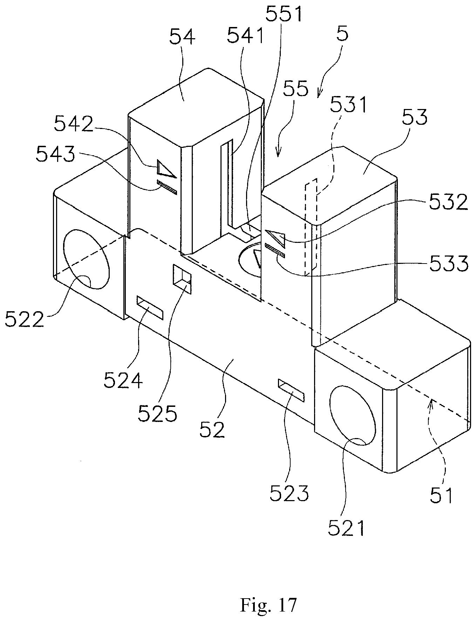

FIG. 17 is a perspective view of the main case 5. The main case 5 includes an internal space for housing the sensor circuit assembly 2 and the holder 3. The bottom surface of the main case 5 is provided with an opening 51. Thus the internal space in the main case 5 opens downward. The sensor circuit assembly 2 and the holder 3 pass through the opening 51 to be arranged in the internal space of the main case 5.

As illustrated in FIG. 17, the main case 5 includes a first mounting hole 521 and a second mounting hole 522 for mounting the main case 5 to various kinds of machinery. The first mounting hole 521 and the second mounting hole 522 pass longitudinally through the main case 5. A front surface 52 of the main case 5 includes a first fastening hole 523 and a second fastening hole 524. As illustrated in FIG. 7, the front surface of the holder 3 includes a first fastening protrusion 391 and a second fastening protrusion 392. The first fastening protrusion 391 locks together with the first fastening hole 523. The second fastening protrusion 392 locks together with the second fastening hole 524. Hereby the main case 5 may be secured to the holder 3. Moreover, as illustrated in FIG. 9, the rear surface of the holder 3 includes a third fastening protrusion 393 and a fourth fastening protrusion 394. Although not illustrated, the rear surface of the main case 5 includes a third fastening hole and a fourth fastening hole. The third fastening protrusion 393 on the holder 3 locks together with the third fastening hole. The fourth fastening protrusion 394 on the holder 3 locks together with the fourth fastening hole.

As illustrated in FIG. 7 and FIG. 9, the holder 3 includes a first end surface 321 and a second end surface 322. The first end surface 321 and the second end surface 322 are one portion of the front surface of the holder 3. The above described first fastening protrusion 391 protrudes frontward from the first end surface 321. The second fastening protrusion 392 protrudes frontward from the second end surface 322. The front end surface 315 of the first wall 31 is located between the first end surface 321 and the second end surface 322 in the left and right direction. The front end surface 315 of the first wall 31 is recessed further behind the first end surface 321 and the second end surface 322.

As illustrated in FIG. 17, the main case 5 includes a light-emitter case 53, a light-receiver case 54, and a detection groove 55. The light-emitter case 53 houses the light emitting element 211. The light-receiver case 54 houses the light receiving element 221. The light-emitter case 53 and the light-receiver case 54 are arranged separated from each other in the left and right direction. The detection groove 55 is located between the light-emitter case 53 and the light-receiver case 54.

The light-emitter case 53 includes a light-emitter slit 531. The light-emitter slit 531 extends vertically. The light-emitter slit 531 extends from at least a location facing the light emitting element 211 up to the bottom of the detection groove 55. More specifically, the light-emitter slit 531 extends from a location facing the light-emitter lens part 212 up to the bottom of the detection groove 55. The light-receiver case 54 includes a light-receiver slit 541. The light-receiver slit 541 is arranged facing the light-emitter slit 531. The light-receiver slit 541 extends vertically. The light-receiver slit 541 extends from at least a location facing the light receiving element 221 up to the bottom of the detection groove 55. The light-receiver slit 541 extends from a location facing the light-receiver lens part 222 up to the bottom of the detection groove 55.

The main case 5 includes element position marks 532, 542 and detection depth marks 533, 543. The element position marks 532, 542 are arranged at positions corresponding to the light receiving element 221 and the light emitting element 211. More specifically, the element position marks 532, 542 are arranged at positions corresponding to the center position of the light-emitter lens part 212 and the center position of the light-receiver lens part 222. The detection depth marks 533, 543 indicate the detection depth required for detecting an object to be detected in the detection groove 55. That is, the light receiving element 221, and the light emitting element 211 will stably detect an object when the object arrives at a location in the detection groove 55 exceeding the detection depth.

The element position marks 532, 542, and the detection depth marks 533, 543 are symbols that are added to the main case 5. The element position marks 532, 542 may be respectively added to the front surfaces of the light-emitter case 53 and the light-receiver case 54. The detection depth marks 533, 543 may be respectively added to the front surfaces of the light-emitter case 53 and the light-receiver case 54. In the present embodiment, the element position marks 532, 542 are triangular symbols. The detection depth marks 533, 543 are bar symbols. Recesses and projections in the main case 5 form the element position marks 532, 542, and the detection depth marks 533, 543. More specifically, the element position marks 532, 542 are hollowed out of the surface of the main case 5. Additionally, the detection depth marks 533, 543 are hollowed out of the surface of the main case 5. Although not illustrated, the element position marks 532, 542 may also be respectively placed on the rear surface of the light-emitter case 53 and the rear surface of the light-receiver case 54. Additionally the detection depth marks 533, 543 may be respectively placed on the rear surfaces of the light-emitter case 53 and the light-receiver case 54.

The main case 5 includes at least one indicator window 525, 551. More specifically, the main case 5 includes a first indicator window 525, a second indicator window 551, and a third indicator window (not shown). The first indicator window 525 is provided on the front surface 52 of the main case 5. The second indicator window 551 is provided on the bottom of the detection groove 55. The third indicator window is provided on the rear surface of the main case 5. The first indicator window 525, the second indicator window 551, and the third indicator window are arranged to face the projection 251 in the sensor circuit assembly 2.

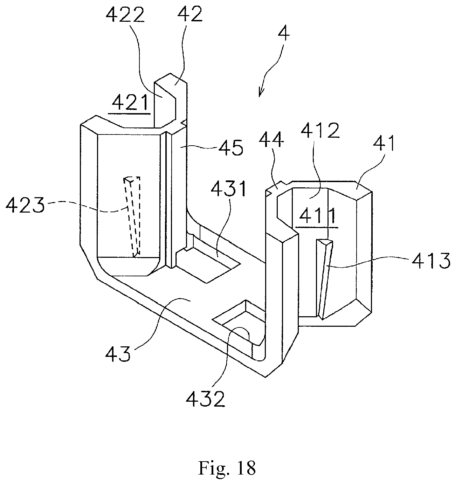

FIG. 18 is a perspective view of the sub case 4. The sub case 4 is arranged between the main case 5 and the sensor circuit assembly 2. The sub case 4 prevents the transmission of disturbance light, while allowing efficient transmission of infrared light. The sub case 4 may be made from resin, for example.

The sub case 4 includes a light-emitter cover 41, a light-receiver cover 42, and a connecting case 43. The connecting case 43 connects the light-emitter cover 41 and the light-receiver cover 42. The light-emitter cover 41 includes a first housing space 411 into which the light emitting element 211 is disposed. The light-emitter cover 41 covers the light emitting element 211 from the light emission direction of the light emitting element 211. Opposite the light emission direction, the first housing space 411 is open across the entire light-emitter cover 41 in the vertical direction. That is, the right portion of the first housing space 411 is entirely open in the vertical direction. The first housing space 411 passes vertically through the light-emitter cover 41.

The light-receiver cover 42 includes a second housing space 421 into which the light receiving element 221 is disposed. The light-receiver cover 42 covers the light receiving element 221 from the light receiving direction of the light receiving element 221. Opposite the light receiving direction, the second housing space 421 is open across the entire light-receiver cover 42 in the vertical direction. That is, the left portion of the second housing space 421 is entirely open in the vertical direction. The second housing space 421 passes vertically through the light-receiver cover 42.

An inner surface 412 near the first housing space 411 of the light-emitter cover 41 tapers toward the light emission direction. In other words, the inner surface 412 of the light-emitter cover 41 tapers towards the light receiving element 221. Therefore, when the sub case 4 is mounted to the sensor circuit assembly 2, the light-emitter lens part 212 comes into contact with the inner surface 412 of the light-emitter cover 41 to thereby position the light-emitter cover 41. An inner surface 422 near the second housing space 421 of the light-receiver cover 42 tapers toward the light receiving direction. In other words, the inner surface 422 of the light-receiver cover 42 tapers toward the light emitting element 211. Therefore, when the sub case 4 is mounted to the sensor circuit assembly 2, the light-receiver lens part 222 comes into contact with the inner surface 422 of the light-receiver cover 42 to thereby position the light-receiver cover 42.

A protrusion 413 is provided on the inner surface 412 of the light-emitter cover 41. The upper end part of the protrusion 413 comes into contact with the bottom surface of the light-emitter lens part 212 when the light-emitter lens part 212 is arranged in the first housing space 411. A protrusion 423 is provided on the inner surface 422 of the light-receiver cover 42. The upper end part of the protrusion 423 comes into contact with the bottom surface of the light-receiver lens part 222 when the light-receiver lens part 222 is arranged in the second housing space 421. Hereby, the sensor circuit assembly 2 is prevented from slipping downward in relation to the sub case 4.

The sub case 4 includes a light-emitter window 44 and a light-receiver window 45. The light-emitter window 44 includes a protrusion that protrudes from the light-emitter cover 41 toward the light emission direction. The light-emitter window 44 extends vertically. The shape of the light-emitter window 44 matches the shape of the above described light-emitter slit 531 in the main case 5. The light-emitter window 44 is inserted into the light-emitter slit 531. The light-receiver window 45 includes a protrusion that protrudes from the light-receiver cover 42 toward the light receiving direction. The light-receiver window 45 extends vertically. The shape of the light-receiver window 45 matches the shape of the above described light-receiver slit 541 in the main case 5. The light-receiver window 45 is inserted into the light-receiver slit 541.

The sub case 4 includes a first indicator opening 431 and a second indicator opening 432. The first indicator opening 431 and the second indicator opening 432 are provided in the connecting case 43. The first indicator opening 431 is arranged facing the projection 251 on the sensor circuit assembly 2. The projection 251 is arranged inside the first indicator opening 431 when the sub case 4 is mounted on the sensor circuit assembly 2. The second indicator opening 432 mirrors the shape of the first indicator opening 431 about a symmetry axis extending in the vertical direction. Additionally, the sub case 4 is symmetrical about the symmetry axis extending in the vertical direction. Accordingly, it is possible to mount the sub case 4 on the sensor circuit assembly 2 in the reverse of the above described orientation. That is, along with mounting the light-emitter cover 41 on the light-receiver lens part 222, the light-receiver cover 42 may be mounted on the light-emitter lens part 212. If mounted in this manner, the projection 251 on the sensor circuit assembly 2 will be arranged inside the second indicator opening 432.

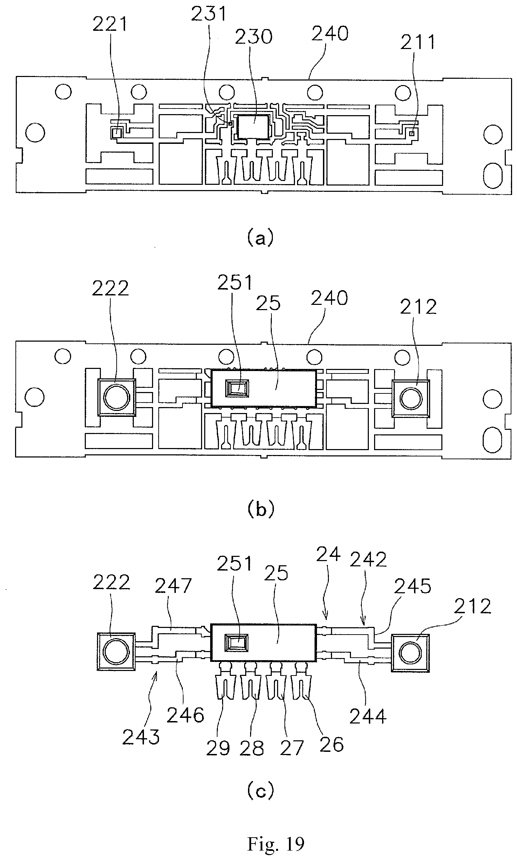

Next, the process of manufacturing the photosensor 1 will be described. FIG. 19 illustrates a process for manufacturing the sensor circuit assembly 2. In the process illustrated in FIG. 19A a sheet like frame is punched via stamping to thereby form a lead frame 240 of a prescribed shape. Further, the IC chip 230 of the circuit 23, the operation indicator 231, the light emitting element 211, and the light receiving element 221 are mounted to the lead frame 240.

Next, in the process illustrated in FIG. 19B, the seal part 25, the light-emitter lens part 212, and the light-receiver lens part 222 are cast on the lead frame 240. The seal part 25, the light-emitter lens part 212, and the light-receiver lens part 222 are all formed from the same of casting material; therefore the seal part 25, the light-emitter lens part 212, and the light-receiver lens part 222 may all be cast at one time from a shared die.

Next, in the process illustrated in FIG. 19C, the unneeded portions of the lead frame 240 are removed to form the above described lead frame 24 for the sensor circuit assembly 2. Thereafter, the light-receiver leads 243, and the light-emitter leads 242 are bent upward. Further, the first to fourth connection terminals 26-29 are bent downward.

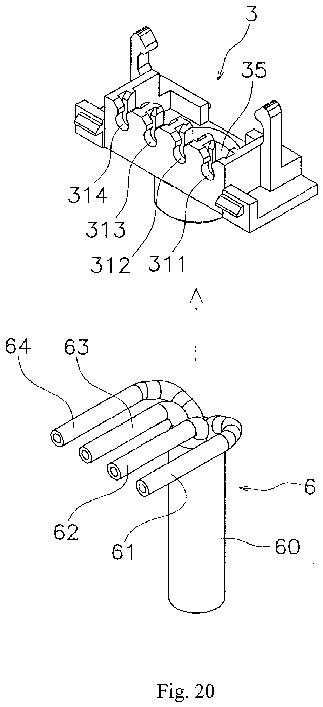

FIG. 20 to FIG. 22 illustrate the assembling of the photosensor 1. First, in the process illustrated in FIG. 20, the cable 6 is installed in the holder 3. To install the cable, a plurality of wires 61-64 are exposed by preliminarily cutting the outer coating 60 at the tip end part of the cable 6. Next, the exposed wires 61-64 and the outer coating 60 of the cable 6 are moved upward toward the holder 3 and inserted into the borehole 35 in the holder 3. Thereafter, the wires 61-64 are pulled toward the front and inserted into the first to fourth wire housings 311-314.

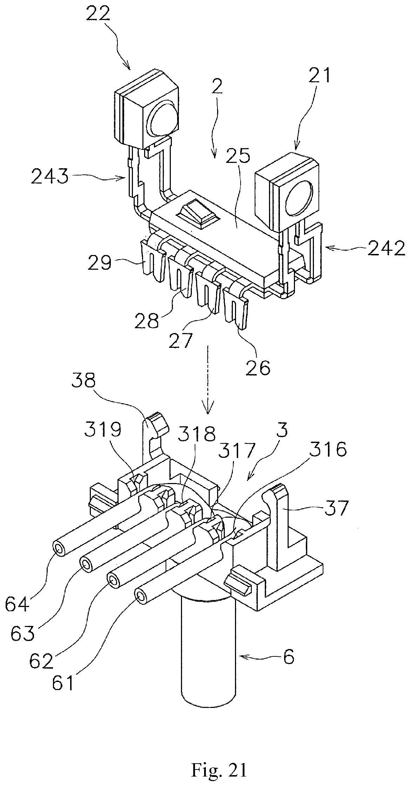

Next, in the process illustrated in FIG. 21, the sensor circuit assembly 2 is mounted on the holder 3. To mount the assembly, the sensor circuit assembly 2 is moved downward toward the holder 3. The first to fourth connection terminals 26-29 are thereby each inserted into the first to fourth terminal housings 316-319. At this point, the first to fourth connection terminals 26-29 pierce the wires 61-64 inside the first to fourth wire housings 311-314, and press into contact with the wires 61-64. When the sensor circuit assembly 2 is pressed downward towards the holder 3 until the sensor circuit assembly 2 is caught on the first catch 37 and the second catch 38 of the holder 3, the first to fourth connection terminals 26-29 arrive at the press-contact position to complete press-contact between the first to fourth connection terminals 26-29 and the wires 61-64. Finally, any excess wires protruding from the front end surface 315 of the first wall 31 are cut.

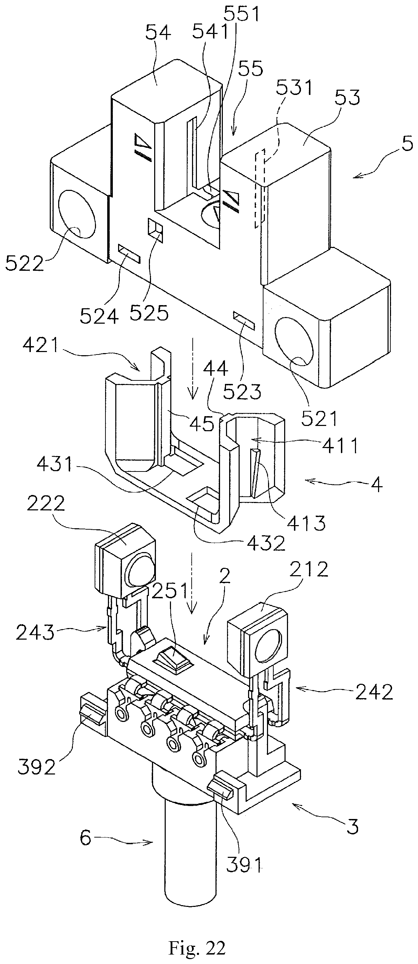

Next, in the process illustrated in FIG. 22, the sub case 4 is mounted on the sensor circuit assembly 2. The sub case 4 is moved downward toward the sensor circuit assembly 2 to cover the sensor circuit assembly 2 with the sub case 4. Hereby, the light-emitter lens part 212 is arranged inside the first housing space 411. Further, the light-receiver lens part 222 is arranged inside the second housing space 421.

The main case 5 is then mounted on the holder 3. The main case 5 is moved downward toward the sensor circuit assembly 2 and the holder 3 to cover the sensor circuit assembly 2, the holder 3, and the sub case 4 with the main case 5. Hereby, the sensor circuit assembly 2, the holder 3, and the sub case 4 are arranged in the internal space in the main case 5. Furthermore, the light-emitter window 44 of the sub case 4 is inserted into the light-emitter slit 531, and the light-receiver window 45 is inserted in the light-receiver slit 541.

The effects of the photosensor 1 according to the present embodiment are as follows. The light emitting element 211, the light receiving element 221, and the seal part 25 are integrated with the photosensor 1. Therefore, it is possible to install the sensor circuit assembly 2, which includes the light emitting element 211, the light receiving element 221, and the seal part 25, in a unified manner in the holder 3. Further, the first to fourth connection terminals 26-29 are pressed into contact with each of the wires 61-64 and soldering is therefore unnecessary. Thus, the number of manufacturing man-hours decreases.

Further, soldering is no longer necessary, therefore even if there is a small distance between the seal part 25 and the first to fourth connection terminals 26-29, it is possible to prevent the effects of heat on the circuit 23 and the seal part 25. Thus, the reliability of the device improves. Moreover, given that the tips of the first to fourth connection terminals 26-29 are arranged oriented downward, moving the sensor circuit assembly 2 downward facilitates pressing the first to fourth connection terminals 26-29 into contact with the wires 61-64. In this manner, the photosensor 1 according to the present embodiment has increased reliability and a reduced number of manufacturing man-hours.

In particular, if the plurality of connection terminals is arranged side by side as in the present embodiment, for a small-sized photosensor the distance between the connection terminals may be extremely small. In this case, it would not be prudent to solder a wire to each of the connection terminals as that would lead to a short circuit between adjacent connection terminals. However, in the photosensor 1 according to the present embodiment, the plurality of connection terminals 26-29 is connected to the wires 61-64 by being pressed into contact therewith, thereby addressing the above-mentioned types of problems.

Moreover, the first connection terminal 26 includes the first pressure part 260, and therefore the first connection terminal 26 may be pressed into contact by pressing down the first pressure part 260. Accordingly, it is possible to reduce the load on the seal part 25 compared to a case where the seal part 25 needs to be pressed to make the press contact. Thus, the reliability of the device improves.

Each of the connection terminals 26-29 protrudes longitudinally from the seal part 25 and curves downward. Therefore, the pressure parts 260, 270, 280, 290 of the connection terminals 26-29 are arranged outside the region on which the seal part 25 projects in the press-contact direction. Accordingly, when the pressure parts 260, 270, 280, 290 of each of the connection terminals 26-29 are pushed from above, the seal part 25 will not obstruct the pressure parts. This facilitates press contact. Additionally the pressure parts 260, 270, 280, 290 are one portion of the edge face of the connection terminals 26-29 as a sheet thickness of the connection terminals 26-29. This thus facilitates the forming of the pressure parts 260, 270, 280, 290. Moreover, the pressure parts 260, 270, 280, 290 are provided on each of the connection terminals 26-29. Therefore, each of the connection terminals 26-29 may be uniformly pressed, compared to providing the pressure part on only one portion of the connection terminals 26-29. Each of the connection terminals 26-29 may thereby be accurately pressed into contact.

Pressing into contact may be achieved by pushing the first to fourth connection terminals 26-29 onto the wires 61-64, so that the first to fourth connection terminals 26-29 cut through the inner coating of the wires 61-64 to come into contact with the cores. Therefore, the terminals may be easily pressed into contact without first cutting the inner coating of the wires 61-64 in advance. Thus, the number of manufacturing steps decreases.

The wire housings 311-314 are mutually partitioned. Therefore, the wires 61-64 may be prevented from coming into contact with each other.

The plurality of wire housings 311-314 extends longitudinally. Accordingly, when manufacturing the photosensor 1, the wires 61-64 may be arranged along the front and rear direction in the wire housings 311-314. Further, moving the connection terminals 26-29 downward and pushing the terminals onto the wires 61-64 thereby facilitates pressing the terminals 26-29 into contact.

The cable 6 is arranged to pass through the borehole 35. The borehole 35 passes vertically through the holder 3. Accordingly, the direction the cable 6 is inserted through the borehole 35, and the direction the wires 61-64 are arranged in the wire housings 311-314 are orthogonal. Therefore, the wires 61-64 will be prevented from pushing up the sensor circuit assembly 2 when the cable 6 is inserted, compared to having the same direction for inserting the cable 6 into the borehole 35, and for arranging the wires 61-64.

The width of the first slot 311c in the first wire housing 311 is smaller than the diameter d2 of the wire 61. Therefore, it is possible to improve the retention force of the first wire housing 311 on the wire 61. In other words, the wire 61 will tend not to slip out from the first wire housing 311. Further, it is possible to have some sense of inserting the wire 61 when the wire 61 passes through the first slot 311c and is inserted into the first wire housing 311. Hereby, when manufacturing the photosensor 1, a worker can easily determine whether installation of the wire 61 into the first wire housing 311 is complete. The second to fourth wire housings 312-314 provide the same effects as the first wire housing 311.

The first to fourth terminal housings 316-319 are mutually partitioned. Therefore, the adjacent connection terminals may be prevented from coming into contact with each other.

The first terminal housing 316 is arranged intersecting with the first wire housing 311. With this arrangement, inserting the first connection terminal 26 into the first terminal housing 316 facilitates the first connection terminal 26 in piercing the wire 61 which is arranged inside the first wire housing 311. The second to fourth connection terminals provide the same effects as the first connection terminal 26.

The first connection terminal 26 is arranged between the pair of first wall surfaces 316a, 316b. Therefore, the amount of deformation of the first connection terminal 26 while the first connection terminal 26 is being pressed into contact is restricted by the pair of first wall surfaces 316a, 316b. Hereby, it is possible to secure a stronger press contact between the first connection terminal 26 and the wire. The second to fourth connection terminals 27-29 provide the same effects as the first connection terminal 26.

The first protrusion 316c protrudes toward the slit 267 in the first connection terminal 26, within the first connection terminal housing 316. Therefore, during press contact, the first protrusion 316c pushes the core 612 of the wire 61 into the slit 267 of the first connection terminal 26. Therefore during press contact, this prevents the core 612 from escaping from the slit 267 in the first connection terminal 26. Hereby, an accurate connection between the first connection terminal 26 and the core 612 may be established. The second to fourth connection terminals 27-29 provide the same effects as the first connection terminal 26.

The first catch 37 and the second catch 38 arrive at the locked position with the sensor circuit assembly 2 while the above described first to fourth connection terminals 26-29 are being arranged in the press-contact position with the wires 61-64. As a result, the locking of the first catch 37 and the second catch 38 onto the sensor circuit assembly 2, maintains a firm initial press contact between the first to fourth connection terminals 26-29 and the wires 61-64. Furthermore, during press contact, when the first to fourth connection terminals 26-29 are arranged in the press-contact position with the wires 61-64, the first catch 37 and the second catch 38 arrive at the locked position with the sensor circuit assembly 2. Therefore, a worker easily determine that press contact of the first to fourth connection terminals 26-29 is complete when the first catch 37 and the second catch 38 lock onto the sensor circuit assembly 2.

The light-emitter leads 242 and the light-receiver leads 243 bend upward. The first to fourth connection terminals 26-29 curve downward. Therefore, when the first to fourth connection terminals 26-29 are pressed downward and pressed into contact with the wires 61-64, the light-emitter leads 242 and the light-receiver leads 243 will tend not to obstruct the pressing into contact.

The first to fourth connection terminals 26-29 are provided on only the first side 252 of the first side 252 and the second side 253. If connection terminals are provided on both the first side 252 and the second side 253, a force must be evenly applied to the connection terminals on the first side 252 and the connection terminals on the second side 253, however this is hard to achieve. Additionally, to apply a force to the connection terminals on the first side 252 and the connection terminals on the second side 253 evenly, the most effective means would be to press down on the seal part 25 which is between the first side 252 and the second side 253, making it likely that the seal part 25 will break. Whereas, in the present embodiment, the first to fourth terminals 26-29 are provided on only the first side 252, and thereby this facilitates evenly pressing the plurality of connection terminals 26-29 into contact.

The width of the first joining part 262 of the first connection terminal 26 is smaller than the width of the first press-contact part 261. Therefore, the first connection terminal 26 may be bent with little force compared to the case where the width of the first joining part 262 and the width of the first press-contact part 261 are the same. In the same manner, the second to fourth connection terminals 27-29 may be bent with little force. Thus, it is possible to reduce the amount of force applied to the seal part 25 of the sensor circuit assembly 2 when bending the first to fourth connection terminals 26-29. This prevents the seal part 25 from breaking during the bending process. Additionally, the first to fourth connection terminals 26-29 may be bent with a small amount of force, and therefore it is possible to improve the precision of the bending angle for the first to fourth connection terminals 26-29.

The first pressure part 260 protrudes outside of the first terminal housing 316. This therefore facilitates pressing the first pressure part 260 when pressing the first connection terminal 26 into contact. This further facilitates pressing the first connection terminal 26 into contact with the wire 61. The second to fourth connection terminals 27-29 provide the same effects as the first connection terminal 26.

The width w3 of the slit 267 in the first connection terminal 26 is smaller than the width w7 of a bundle of a plurality of cores 612 that are not in press contact. In this case, the bundle of cores 612 are sandwiched by the slit 267 in the first connection terminal 26 to firmly connect the cores 612 and the first connection terminal 26. The second to fourth connection terminals 27-29 provide the same effects as the first connection terminal 26.

The inner surface of the borehole 35 in the holder 3 includes the first to fourth protrusions 354-357. Accordingly, the first to fourth protrusions 354-357 establish a uniform gap between the inner surface of the borehole 35 and the outer surface of the cable 6. Therefore, a uniform amount of adhesive may be poured in between the borehole 35 and the cable 6 when bonding the cable 6 to the borehole 35. This improves the strength of the adhesive bonding of the cable 6.

The inner diameter of the second bore section 352 is larger than the inner diameter of the first bore section 351 in the borehole 35 in the holder 3. Additionally the inner diameter of the second bore section 352 is larger towards the end section of the borehole 35. Therefore, this facilitates pouring an adhesive between the borehole 35 and the cable 6. This reduces the occurrence of defective bonding.

The positioning section 36 in the holder 3 is arranged to overlap with one portion of the borehole 35 at the upper portion of the borehole 35. Therefore, this facilitates positioning of the upper end section of the outer coating 60 of the cable 6. Additionally, the positioning section 36 is a portion of the first wall 31. Accordingly, the first wall 31 may also serve as a positioning section 36.

The area of the light-receiver lens part 222 differs from the area of the light-emitter lens part 212. Therefore, the area of the light-emitter lens part 212 and the area of the light-receiver lens part 222 may be a size that is appropriate for the light emitting element 211 and the light receiving element 221 respectively. Additionally, the light emitting element 211 and the light receiving element 221 are integrally installed on the lead frame 24, and therefore the light-emitter lens part 212 and the light-receiver lens part 222 may be cast at the same time when manufacturing the sensor circuit assembly 2. Therefore, even if the area of the light-emitter lens part 212 and the area of the light-receiver lens part 222 are different, it is possible to cast the light-emitter lens part 212 and the light-receiver lens part 222 with a shared mold without having to use individual molds. Hereby, the number of manufacturing man-hours and the cost decrease.

While the cable 6 is installed in the holder 3 by moving the cable 6 upward towards the holder 3, the sensor circuit assembly 2 is installed on the holder 3 by moving the sensor circuit assembly 2 downward toward the holder 3. Additionally, the sub case 4 and the main case 5 are moved downward toward the holder 3 to be mounted on the holder 3. Accordingly, after installing the cable 6 in the holder 3, the sensor circuit assembly 2, the sub case 4, and the main case 5 may be assembled onto the holder 3 in order in the same direction. This facilitates the assembling of the photosensor 1.

The main case 5 includes the detection depth marks 533, 543. The detection depth marks 533, 543 indicate the detection depth for the light emitting element 211 and the light receiving element 221 in the detection groove 55. Accordingly, an operator may use the detection depth marks 533, 543 to easily determine the detection depth. Additionally, the detection depth marks 533, 543 made up of recesses, and therefore the detection depth marks 533, 543 may also function to prevent the photosensor 1 from slipping.

The claims are not limited to the above-mentioned embodiments, and may be modified in various ways insofar as the modifications do not depart from the spirit and scope of the invention.

The present invention is not limited to a transmissive photosensor, and may be applied to a reflective photosensor.

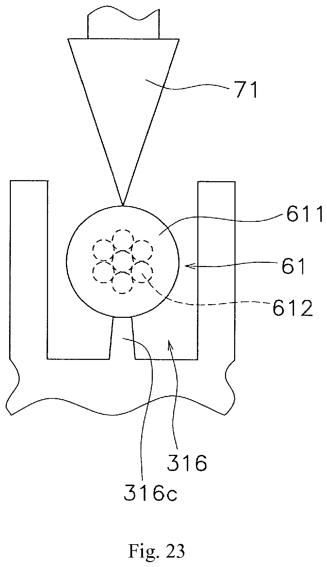

In an example not being part of the invention, the connection terminals may be pointed similarly to a connection terminal 71 illustrated in FIG. 23. The connection terminal 71 pierces the wire 61 to connect with the wire 61. In this case, the connection terminal 71 pierces the wire 61 and comes into contact with the core 612 to thereby electrically connect the connection terminal 71 and the wire 61. Alternatively, the connection terminal may be arranged to pass through the seal part. In this case, pressing the end part of the connection terminal from above the seal part thereby presses the connection terminal into contact with the wire.

The material used for the light-emitter lens part 212, the light-receiver lens part 222, and the seal part 25 is not limited to the above described material. For example, the light-emitter lens part 212, the light-receiver lens part 222, and the seal part 25 may be formed from a material other than resin. Additionally, the light-emitter lens part 212, the light-receiver lens part 222, and the seal part 25 may be made from different materials. However, to integrally cast the light-emitter lens part 212, the light-receiver lens part 222, and the seal part 25, it is preferable for the light-emitter lens part 212, the light-receiver lens part 222, and the seal part 25 to be formed of the same material. The seal part 25 is not limited to sealing only one portion of the lead frame 24, and may seal the entire lead frame 24.

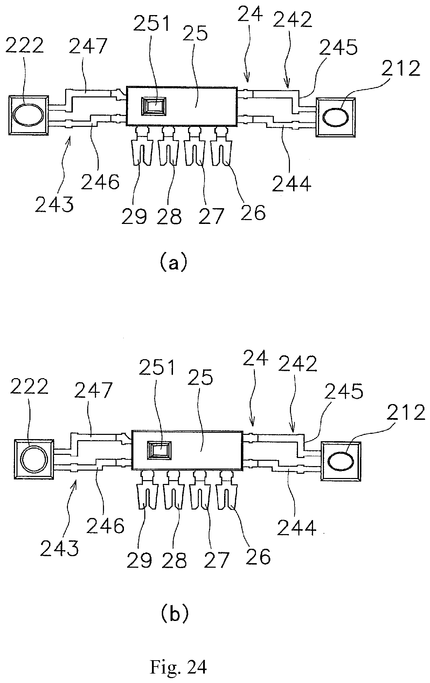

The light-emitter lens part 212 and the light-receiver lens part 222 are not limited to the shape of a circle. For example, as illustrated in FIG. 24A, the light-emitter lens part 212 and the light-receiver lens part 222 may be the shape of an ellipse. Alternatively, as illustrated in FIG. 24B, one of the light-emitter lens part 212 and the light-receiver lens part 222 may be a circle, while the other is an ellipse. Moreover, in FIG. 24B the light-emitter lens part 212 is an ellipse and the light-receiver lens part 222 is a circle; however the light-emitter lens part 212 may be a circle, while the light-receiver lens part 222 is an ellipse.

The light-emitter leads 242 and the light-receiver leads 243 may have mutually asymmetrical shapes. The first light-emitter lead 244 and the second light-emitter lead 245 may have the same or symmetrical shapes. The first light-receiver lead 246 and the second light-receiver lead 247 may have the same or symmetrical shapes.

The number of connection terminals is not limited to four. The sensor circuit assembly 2 may have less than four, or more than four connection terminals. The sensor circuit assembly 2 may have less than four, or more than four wire housings to match the number of connection terminals. Additionally the sensor circuit assembly 2 may have less than four, or more than four terminal housings to match the number of connection terminals. The number of protrusions on the inner surface of the borehole 35 is not limited to four, and may be no less than three. Furthermore, the operation indicator 231 may be omitted from the sensor circuit assembly 2.

The arrangement of the plurality of connection terminals is not limited to the above-mentioned arrangements in the embodiment. For example, the plurality of connection terminals may be provided on both the first side 252 and the second side 253 of the seal part 25. However, if the plurality of connection terminals is provided on both the first side 252 and the second side 253 of the seal part 25, it will be necessary to provide a uniform force to press down on the connection terminals on the first side 252, and the connection terminals on the second side 253 during press contact. Accordingly, in an effort to simplify production of the photosensor, the plurality of connection terminals may be preferably provided on only one side of either the first side 252 or the second side 253 of the seal part 25.

Additionally, in the above-mentioned embodiment the shape of the seal part 25 is a square in a plan view, in other words when viewed from above, however the seal part may have another shape. For example, the seal part may be a triangle in a plan view. Even in this case, providing the connection terminals on only one of a pair of mutually opposite sides thereby allows the connection terminals to be pressed with an even amount of force in the same manner as in the above-mentioned embodiment.

The width of the slit in the connection terminal may be smaller than the diameter of the core. In this case, when the core is deformed and pushed into the slit, the core and the connection terminal are firmly connected.

In the above-mentioned embodiment, the excess wire is cut after the first to fourth connection terminals 26-29 are pressed into contact with the wires 61-64. However, the excess wire may be cut before the first to fourth connection terminals 26-29 are pressed into contact with the wires 61-64.

The detection depth marks 533, 543 are not limited to being recessed from the surface of the main case 5, and may be projections protruding from the surface of the main case 5. Alternatively, the detection depth marks 533, 543 may have some kind of surface roughness that is rougher than the other segments of the main case 5.

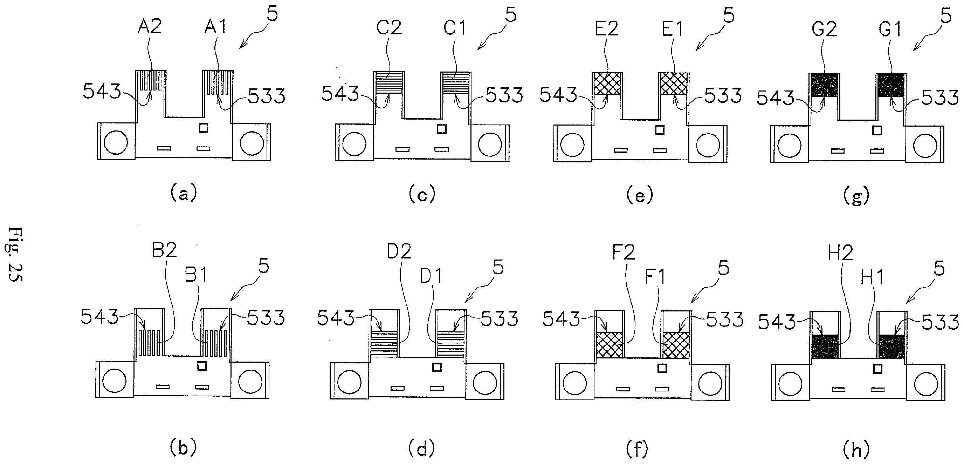

The element position marks 532, 542 are not limited to the above described triangles, but may be another shape. The detection depth marks 533, 543 are not limited to the above described bars, but may be another shape. For example, as illustrated in FIG. 25, the main case 5 may be given a pattern or a color different from other segments, where the boundary of the pattern or the color represent the detection depth marks 533, 543.

In FIG. 25A, patterns A1, A2 constituted by a plurality of straight lines are added to the main case 5. Each straight-line extends vertically, and is arranged horizontally side by side. The lower boundaries of the patterns A1, A2, in other words the lower end sections of each of the straight lines correspond to the detection depth marks 533, 543. In FIG. 25B, patterns B1, B2 constituted by a plurality of straight lines are added to the main case 5. Each straight-line extends vertically, and is arranged horizontally side by side. The upper boundaries of the patterns B1, B2, in other words the lower end sections of each of the straight lines correspond to the detection depth marks 533, 543. Additionally, the patterns A1, A2, B1, B2 may be constituted by recesses and projections. Alternatively, the patterns A1, A2, B1, B2 may have a rougher surface roughness than the other segments of the main case 5.

In FIG. 25C, patterns C1, C2 constituted by a plurality of straight lines are added to the main case 5. Each straight-line extends horizontally, and are arranged vertically in a row. The lower boundaries of the patterns C1, C2, in other words the straight line at the lowest position corresponds to the detection depth marks 533, 543. In FIG. 25D, patterns D1, D2 constituted by a plurality of straight lines are added to the main case 5. Each straight-line extends horizontally, and are arranged vertically in a row. The upper boundaries of the patterns D1, D2, in other words the straight line at the highest position, correspond to the detection depth marks 533, 543. Additionally, the patterns C1, C2, D1, D2 may be constituted by recesses and projections. Alternatively, the patterns C1, C2, D1, D2 may have a coarser surface roughness than the other segments of the main case 5.

In FIG. 25E, meshed patterns E1, E2 are added to the main case 5. The lower boundaries of the patterns E1, E2 correspond to the detection depth marks 533, 543. In FIG. 25F, meshed patterns F1, F2 are added to the main case 5. The upper boundaries of the patterns F1, F2 correspond to the detection depth marks 533, 543. Additionally, the patterns E1, E2, F1, F2 may be constituted by recesses and projections. Alternatively, the patterns E1, E2, F1, F2 may have a coarser surface roughness than the other segments of the main case 5.

In FIG. 25G, one portion of the main case 5 has a different color from the other segments of the case. The lower boundaries of the different-colored segments G1, G2, correspond to the detection depth marks 533, 543. In FIG. 25H, one portion of the main case 5 has a different color from the other segments of the case. The upper boundaries of the different-colored segments HI, H2, correspond to the detection depth marks 533, 543. Additionally the segments G1, G2, HI, H2 may be constituted by recesses and projections. Alternatively, the segments G1, G2, HI, H2 may have a coarser surface roughness than the other segments of the main case 5.

As long as the light-emitter support supports the light emitting element, the shape and structure thereof is not limited to the above described embodiment. For example, the light-emitter support may be a lead as in the above-mentioned embodiment, or maybe another structure configuration such as a pattern formed over a resin material. The light-emitter support is not limited to extending in the vertical direction as in the above-mentioned embodiment, and may extend in another direction. For example, the light-emitter support may extend in a direction inclined in relation to the vertical direction. The light-emitter support is not limited to being linear, and may be another shape. For example, the light-emitter support may be curved. As long as the light-receiver support supports the light receiving element, the shape and structure thereof is not limited to the above described embodiment. For example, the light-receiver support may be a lead as in the above-mentioned embodiment, or maybe another structure configuration such as a pattern formed over a resin material. The light-receiver support is not limited to extending in the vertical direction as in the above-mentioned embodiment, and may extend in another direction. For example, the light-receiver support may extend in a direction inclined in relation to the vertical direction. The light-receiver support is not limited to being linear, and may be another shape. For example, the light-receiver support may be curved.

## Claims

1. A photosensor (1) comprising: a sensor circuit assembly (2) including: a light emitting element (211) and a light receiving element (221) that face each other;
a light-emitter support (210) that extends from the light emitting element (211) and supports the light emitting element (211);
a light-receiver support (220) that extends from the light receiving element (221) and supports the light receiving element (221);
and a connecting part (20) that connects one end of the light-emitter support (210) and one end of the light-receiver support (221);
the connecting part (20) comprising:
a lead frame (24),
a seal part (25) sealing at least a portion of the lead frame (24); and
a plurality of connection terminals (26 - 29) including a first connection terminal (26) which is connected to the lead frame (24) and protrudes from the seal part (25);
**characterized in that** the first connection terminal (26) comprises:
a first press-contact part (261) configured to establish contact with a first wire (61) by being pressed in a press-contact direction,
a first pressure part (260) configured to be used to press the first press-contact part (261) in the press-contact direction; and
a joining part (262) that connects the first press-contact part (261) to the lead frame (24), the first connection terminal (26) being bent in the press-contact direction at the joining part (262), wherein the photosensor (1) comprises: a holder (3) that supports the first wire (61); and
the holder (3) includes:
a first wire housing (311) that houses the first wire (61); and
a first terminal housing (316) that houses the first connection terminal (26); wherein the first wire (61) is pressed into contact with the first connection terminal (26) within the first wire housing (311),
wherein the first press-contact part (261) of the first connection terminal (26) includes a slit (267), whe
rein the first terminal housing (316) includes a protrusion (316c);
the protrusion (316c) protrudes from a bottom of the first terminal housing (316) toward the slit (267); and
the bottom of the first terminal housing (316) faces a tip end of the first connection terminal (26) when the first terminal housing (316) houses the first connection terminal (26).

2. The photosensor (1) according to claim 1 wherein the first pressure part (260) of the first connection terminal (26) is arranged outside a region of the seal part (25) when looking at the seal part (25) in the press-contact direction.

3. The photosensor (1) according to claim 1 or 2 wherein the width of the joining part (262) is smaller than the width of the first press-contact part (261).

4. The photosensor (1) according to any one of claims 1 through 3, wherein the first pressure part (260) of the first connection terminal (26) is one portion of an edge face of the first connection terminal (26) as a sheet thickness of the first connection terminal (26).

5. The photosensor (1) according to any one of claims 1 through 4 comprising: a first wire (61) configured to connect to the sensor circuit assembly (2); and
the first press-contact part (261) of the first connection terminal (26) contacts the first wire (61) along the press-contact direction.

6. The photosensor (1) according to claim 5 comprising: a second wire (62) configured to connect to the sensor circuit assembly (2);
the plurality of connection terminals (26 - 29) include a second connection terminal (27) which protrudes from the seal part (25); and
the second connection terminal (27) is pressed into contact with the second wire (62) in the press-contact direction.

7. The photosensor (1) according to claim 6 wherein the second connection terminal (27) comprises a second press-contact part (271), and a second pressure part (270) configured to be used to press the second press-contact part (271) in the press-contact direction.

8. The photosensor (1) according to claim 6 or 7 wherein the seal part (25) includes a first side (252) and a second side (253);
the first and second sides (252,253) are positioned opposite to each other;
the first connection terminal (26) and the second connection terminal (27) are on the first side (252); and
the second side (253) lacks a connection terminal.

9. The photosensor (1) according to any one of claims 6 through 8 comprising: a holder (3) that supports the first wire (61) and the second wire (62);
the holder (3) includes:
a first wire housing (311) that houses the first wire (61);
a second wire housing (312) that houses the second wire (62);
a first terminal housing (316) that houses the first connection terminal (26); and
a second terminal housing (317) that houses the second connection terminal (27); wherein
the first wire housing (311) and the second wire housing (312) are mutually partitioned;
the first wire (61) press contacts the first connection terminal (26) within the first wire housing (311); and
the second wire (62) press contacts the second connection terminal (27) within the second wire housing (312).

10. The photosensor (1) according to any one of claims 6 through 9 comprising: a cable (6) including the first wire (61), the second wire (62), and an outer coating (60) that covers the first wire (61) and the second wire (62); and
a holder (3) that supports the cable (6); wherein
the holder (3) includes a borehole (35) that passes therethrough;
an inner surface of the borehole (35) has at least three protrusions (354, 355, 356);
the cable (6) passes through the borehole (35); and
an adhesive fills space between the inner surface of the borehole (35) and the cable (6).

11. The photosensor (1) according to claim 10 wherein the borehole (35) includes a first bore section (351) and a second bore section (352);
the first bore section (351) and the second bore section (352) are side by side in the axial direction of the borehole (35);
the second bore section (352) includes an end section of the borehole (35); and
the inner diameter of the second bore section (352) is larger than the inner diameter of the first bore section (351).

12. The photosensor (1) according to any one of claims 10 through 11 wherein the holder (3) includes:
a wall (31) that overlaps a portion of the borehole (35), the wall (31) including a first wire housing (311) that houses the first wire (61); and a second wire housing (312) that houses the second wire (62); and
a positioning section (36) constituted by one portion of the wall (31) that overlaps a portion of the borehole (35) in the direction wherein the borehole passes through the holder (3).

13. The photosensor (1) according to any one of claims 1 through 12 wherein the sensor circuit assembly (2) includes a light-emitter lens part (212) that covers the light emitting element (211), and a light-receiver lens part (222) that covers the light receiving element (221); and
the light-receiver lens part (222) and the light-emitter lens part (212) have different shapes.

14. The photosensor (1) according to any one of claims 5 through 13 comprising: a cable (6) including the first wire (61);
a holder (3) that supports the sensor circuit assembly (2) and the cable (6);
and a main case (5) having an internal space with an opening that encloses the sensor circuit assembly (2) and the holder (3); wherein
the holder (3) includes a borehole (35) in a downward press-contact direction;
the cable (6) passes through the borehole (35); and
the holder (3) includes a first wire housing (311) that houses the first wire (61); and a first terminal housing (316) that houses the first connection terminal (26); wherein
the first wire housing (311) has a long axis extending in a direction that intersects the downward press-contact direction and opens upward;
the first terminal housing (316) intersects the first wire housing (311) and opens upward;
the sensor circuit assembly (2) is mounted on the top of the holder (3); and
a tip end of the first connection terminal (26) faces downward;
the first press-contact part (261) of the first connection terminal (26) pierces the first wire (61) from above in the first wire housing (311) and is thereby pressed into contact with the first wire (61);
the internal space opening in the main case (5) faces down; and
the main case (5) is mounted onto the top of the holder (3).

15. The photosensor (1) according to any one of claims 1 through 14 comprising: a holder (3) that supports the sensor circuit assembly (2);
and a main case (5) that houses the sensor circuit assembly (2) and the holder (3); wherein
the main case (5) includes:
a light-emitter case (53) that houses the light emitting element (211);
a light-receiver case (54) that houses the light receiving element (221); and
a detection groove (55) located between the light-emitter case (53) and the light-receiver case (54); and
the main case (5) includes a mark (533, 543); wherein
the mark(533,543) indicates detection depth required for an object to be detected in the detection groove (55).

16. The photosensor (1) according to any one of claims 6 through 15 comprising: a cable (6) including the first wire (61) and the second wire (62);
a holder (3) that supports the sensor circuit assembly (2) and the cable (6);
and a main case (5) that includes an internal space with an opening that houses the sensor circuit assembly (2) and the holder (3); wherein
the holder (3) includes a borehole (35) in a downward press-contact direction; and
the cable (6) passes through the borehole (35); and
the holder (3) includes:
a first wire housing (311) that houses the first wire (61);
a second wire housing (312) that houses the second wire (62);
a first terminal housing (316) that houses the first connection terminal (26); and
a second terminal housing (317) that houses the second connection terminal (27); wherein
the first wire housing (311) and the second wire housing (312) extend in a direction that intersects the downward press-contact direction and that open upward; and
the first terminal housing (316) intersects the first wire housing (311) and opens upward; and
the second terminal housing (317) intersects the second wire housing (312), and opens upward; and
a tip end of the first connection terminal (26) and a tip end of the second connection terminal (27) face downward; and
the first connection terminal (26) is pressed into contact with the first wire (61) within the first wire housing (311); and
the second connection terminal (27) is pressed into contact with the second wire within the second wire housing (312).

## Patentansprüche

1. Photosensor (1) umfassend: eine Sensorschaltkreisanordnung (2) enthaltend: ein lichtemittierendes Element (211) und ein lichtempfangendes Element (221), die sich gegenüberliegen;
einen Lichtemitterträger (210), der sich von dem lichtemittierenden Element (211) aus erstreckt und das lichtemittierendes Element (211) trägt;
einen Lichtempfängerträger (220), der sich von dem lichtempfangenden Element (221) aus erstreckt und das lichtempfangende Element (221) trägt;
und ein Verbindungsteil (20), das ein Ende des Lichtemitterträgers (210) und ein Ende des Lichtempfängerträgers (221) verbindet;
das Verbindungsteil (20) umfasst:
einen Leiterrahmen (24),
ein Dichtungsteil (25), das mindestens einen Teil des Leiterrahmens (24) abdichtet; und
eine Vielzahl von Anschlussklemmen (26 - 29) einschließlich einer ersten Anschlussklemme (26), die mit dem Leiterrahmen (24) verbunden ist und aus dem Dichtungsteil (25) herausragt;
**dadurch gekennzeichnet, dass** die erste Anschlussklemme (26) umfasst:
ein erstes Druckkontaktteil (261), welches dazu eingerichtet ist, dass es einen Kontakt mit einem ersten Draht (61) herstellt, indem es in eine Druckkontaktrichtung gedrückt wird,
ein erstes Druckteil (260), welches dazu eingerichtet ist, dass es zum Drücken des ersten Druckkontaktteils (261) in die Druckkontaktrichtung verwendet wird; und
ein Verbindungsteil (262), das das erste Druckkontaktteil (261) mit dem Leiterrahmen (24) verbindet, wobei die erste Anschlussklemme (26) am Verbindungsteil (262) in die Druckkontaktrichtung gebogen ist,
wobei der Photosensor (1) umfasst: einen Halter (3), der den ersten Draht (61) trägt; und
der Halter (3) umfasst:
ein erstes Drahtgehäuse (311), das den ersten Draht (61) aufnimmt; und
ein erstes Anschlussgehäuse (316), das die erste Anschlussklemme (26) aufnimmt; wobei der erste Draht (61) innerhalb des ersten Drahtgehäuses (311) mit der ersten Anschlussklemme (26) in Kontakt gedrückt wird,
wobei das erste Druckkontaktteil (261) der ersten Anschlussklemme (26) einen Schlitz (267) aufweist,
wobei das erste Anschlussgehäuse (316) einen Vorsprung (316c) aufweist;
der Vorsprung (316c) erstreckt sich von einem Boden des ersten Anschlussgehäuses (316) in Richtung des Schlitzes (267); und
der Boden des ersten Anschlussgehäuses (316) einem spitzen Ende der ersten Anschlussklemme (26) gegenüberliegt, wenn das erste Anschlussgehäuse (316) die erste Anschlussklemme (26) aufnimmt.

2. Photosensor (1) gemäß Anspruch 1, wobei das erste Druckteil (260) der ersten Anschlussklemme (26), bei Betrachtung des Dichtungsteils (25) entlang der Druckkontaktrichtung, außerhalb eines Bereichs des Dichtungsteils (25) angeordnet ist.

3. Photosensor (1) gemäß Anspruch 1 oder 2, wobei die Breite des Verbindungsteils (262) kleiner als die Breite des ersten Druckkontaktteils (261) ist.

4. Photosensor (1) gemäß einem der Ansprüche 1 bis 3, wobei der erste Druckteil (260) der ersten Anschlussklemme (26) ein Abschnitt einer Kantenfläche der ersten Anschlussklemme (26) als Blechdicke der ersten Anschlussklemme (26) ist.

5. Photosensor (1) gemäß einem der Ansprüche 1 bis 4, umfassend: einen ersten Draht (61), das dazu konfiguriert ist, dass es mit der Sensorschaltkreisanordnung (2) verbunden werden kann; und
das erste Presskontaktteil (261) der ersten Anschlussklemme (26) kontaktiert den ersten Draht (61) entlang der Druckkontaktrichtung.

6. Photosensor (1) gemäß Anspruch 5 umfassend: einen zweiten Draht (62), der dazu konfiguriert ist, mit der Sensorschaltkreisanordnung (2) verbunden zu werden;
die Vielzahl von Anschlussklemmen (26 - 29) umfassen eine zweite Anschlussklemme (27), die aus dem Dichtungsteil (25) herausragt; und
die zweite Anschlussklemme (27) wird in die Druckkontaktrichtung in Kontakt mit dem zweiten Draht (62) gedrückt.

7. Photosensor (1) gemäß Anspruch 6, wobei die zweite Anschlussklemme (27) ein zweites Druckkontaktteil (271) und ein zweites Druckteil (270) umfasst, das so konfiguriert ist, dass er zum Drücken des zweiten Druckkontaktteils (271) in die Druckkontaktrichtung verwendet wird.

8. Photosensor (1) gemäß Anspruch 6 oder 7, wobei das Dichtungsteil (25) eine erste Seite (252) und eine zweite Seite (253) umfasst;
die erste und die zweite Seite (252, 253) sind einander gegenüberliegend angeordnet;
die erste Anschlussklemme (26) und die zweite Anschlussklemme (27) sind auf der ersten Seite (252); und
die zweite Seite (253) hat keine Anschlussklemme.

9. Photosensor (1) gemäß einem der Ansprüche 6 bis 8 umfassend: einen Halter (3), der
den ersten Draht (61) und den zweiten Draht (62) trägt;
der Halter (3) umfasst:
ein erstes Drahtgehäuse (311), das den ersten Draht (61) aufnimmt;
ein zweites Drahtgehäuse (312), das den zweiten Draht (62) aufnimmt;
ein erstes Anschlussgehäuse (316), in dem die erste Anschlussklemme (26) untergebracht ist; und
ein zweites Anschlussgehäuse (317), in dem die zweite Anschlussklemme (27) untergebracht ist;
wobei das erste Drahtgehäuse (311) und das zweite Drahtgehäuse (312) voneinander getrennt sind;
der erste Draht (61) druckkontaktiert die erste Anschlussklemme (26) innerhalb des ersten Drahtgehäuses (311); und
der zweite Draht (62) druckkontaktiert die zweite Anschlussklemme (27) innerhalb des zweiten Drahtgehäuses (312).

10. Photosensor (1) gemäß einem der Ansprüche 6 bis 9, umfassend: ein Kabel (6) umfassend
den ersten Draht (61), den zweiten Draht (62) und eine äußere Beschichtung (60), die den ersten Draht (61) und den zweiten Draht (62) bedeckt; und
einen Halter (3), der das Kabel (6) trägt; wobei
der Halter (3) ein Bohrloch (35) enthält, das durch diesen hindurchgeht;
eine Innenfläche des Bohrlochs (35) weist mindestens drei Vorsprünge (354, 355, 356) auf;
das Kabel (6) erstreckt sich durch das Bohrloch (35); und
ein Klebstoff füllt den Raum zwischen der Innenfläche des Bohrlochs (35) und dem Kabel (6).

11. Photosensor (1) gemäß Anspruch 10, wobei das Bohrloch (35) einen ersten Bohrungsabschnitt (351) und einen zweiten Bohrungsabschnitt (352) enthält;
der erste Bohrungsabschnitt (351) und der zweite Bohrungsabschnitt (352) liegen in axialer Richtung des Bohrlochs (35) nebeneinander;
der zweite Bohrungsabschnitt (352) umfasst einen Endabschnitt des Bohrlochs (35); und
der Innendurchmesser des zweiten Bohrungsabschnitts (352) ist größer als der Innendurchmesser des ersten Bohrungsabschnitts (351).

12. Photosensor (1) gemäß einem der Ansprüche 10 bis 11, wobei der Halter (3) umfasst:
eine Wand (31), die einen Teil des Bohrlochs (35) überlappt, die Wand (31) enthält ein erstes Drahtgehäuse (311), welches den ersten Draht (61) aufnimmt; und ein zweites Drahtgehäuse (312), das den zweiten Draht (62) aufnimmt; und
einen Positionierungsabschnitt (36), der durch einen Teil der Wand (31) gebildet wird, der einen Teil des Bohrlochs (35) in die Richtung überlappt, in der das Bohrloch durch den Halter (3) verläuft.

13. Photosensor (1) gemäß einem der Ansprüche 1 bis 12, wobei die Sensorschaltkreisanordnung (2) ein Lichtemitterlinsenteil (212) umfasst, das das lichtemittierende Element (211) abdeckt, und ein Lichtempfängerlinsenteil (222), das das lichtempfangende Element (221) abdeckt; und
das Lichtemitterlinsenteil (222) und das Lichtempfängerlinsenteil (212) haben unterschiedliche Formen.

14. Photosensor (1) gemäß einem der Ansprüche 5 bis 13, umfassend: ein Kabel (6) mit dem
erster Draht (61);
einen Halter (3), der die Sensorschaltkreisanordnung (2) und das Kabel (6) trägt;
und ein Hauptgehäuse (5) mit einem Innenraum mit einer Öffnung, das die Sensorschaltkreisanordnung (2) und den Halter (3) umschließt; wobei
der Halter (3) enthält eine Bohrung (35) in eine nach unten gerichtete Druckkontaktrichtung;
das Kabel (6) verläuft durch das Bohrloch (35); und
der Halter (3) umfasst ein erstes Drahtgehäuse (311), das den ersten Draht (61) aufnimmt; und ein erstes Anschlussgehäuse (316), das die erste Anschlussklemme (26) aufnimmt; wobei
das erste Drahtgehäuse (311) eine Längsachse hat, die sich in einer Richtung erstreckt, die die nach unten gerichtete Druckkontaktrichtung schneidet und sich nach oben öffnet;
das erste Anschlussgehäuse (316) schneidet das erste Drahtgehäuse (311) und öffnet sich nach oben;
die Sensorschaltkreisanordnung (2) ist oben auf dem Halter (3) montiert; und
ein spitzes Ende der ersten Anschlussklemme (26) zeigt nach unten;
das erste Druckkontaktteil (261) der ersten Anschlussklemme (26) durchstößt den ersten Draht (61) von oben im ersten Drahtgehäuse (311) und wird dadurch in Kontakt mit dem ersten Draht (61) gedrückt;
der Innenraum im Hauptgehäuse (5) zeigt nach unten; und
das Hauptgehäuse (5) ist auf der Oberseite des Halters (3) montiert.

15. Photosensor (1) gemäß einem der Ansprüche 1 bis 14 umfassend: einen Halter (3), der die Sensorschaltkreisanordnung (2);
und ein Hauptgehäuse (5), das die Sensorschaltkreisanordnung (2) und den Halter (3) aufnimmt; wobei
das Hauptgehäuse (5) umfasst:
ein Lichtemittergehäuse (53), in dem das lichtemittierende Element (211) untergebracht ist;
ein Lichtempfängergehäuse (54), in dem das lichtempfangende Element (221) untergebracht ist; und
eine Detektionsrille (55), die zwischen dem Lichtemittergehäuse (53) und dem Lichtempfängergehäuse (54) angeordnet ist; und
das Hauptgehäuse (5) eine Markierung (533, 543) enthält; wobei
die Markierung (533,543) die Erfassungstiefe angibt, die für ein in der Detektionsrille (55) zu detektierendes Objekt erforderlich ist.

16. Photosensor (1) gemäß einem der Ansprüche 6 bis 15, umfassend: ein Kabel (6) umfassend den
ersten Draht (61) und den zweiten Draht (62);
einen Halter (3), der die Sensorschaltkreisanordnung (2) und das Kabel (6) trägt;
und ein Hauptgehäuse (5), das einen Innenraum mit einer Öffnung aufweist, der die Sensorschaltkreisanordnung (2) und den Halter (3) aufnimmt; wobei
der Halter (3) ein Bohrloch (35) in einer nach unten gerichteten Drucckontaktrichtung umfasst; und
das Kabel (6) verläuft durch das Bohrloch (35); und
der Halter (3) umfasst:
ein erstes Drahtgehäuse (311), das den ersten Draht (61) aufnimmt;
ein zweites Drahtgehäuse (312), das den zweiten Draht (62) aufnimmt;
ein erstes Anschlussgehäuse (316), in dem die erste Anschlussklemme (26) untergebracht ist; und
ein zweites Anschlussgehäuse (317), in dem die zweite Anschlussklemme (27) untergebracht ist;
wobei sich das erste Drahtgehäuse (311) und das zweite Drahtgehäuse (312) in einer Richtung erstrecken, die die nach unten gerichtete Druckkontaktrichtung schneidet und die sich nach oben öffnen; und
das erste Anschlussgehäuse (316) schneidet das erste Drahtgehäuse (311) und öffnet sich nach oben; und
das zweite Anschlussgehäuse (317) schneidet das zweite Drahtgehäuse (312) und öffnet sich nach oben;
und
ein spitzes Ende der ersten Anschlussklemme (26) und ein spitzes Ende der zweiten Anschlussklemme (27) sind nach unten gerichtet; und
die erste Anschlussklemme (26) wird mit dem ersten Draht (61) innerhalb des ersten
Drahtgehäuses (311) in Kontakt gedrückt; und
die zweite Anschlussklemme (27) wird mit dem zweiten Draht (62) innerhalb des zweiten
Drahtgehäuses (312) in Kontakt gedrückt.

## Revendications

1. Photodétecteur (1), comprenant : un montage de circuits de capteur (2) comprenant : un élément d'émission de lumière (211) et un élément de réception de lumière (221) qui se font face ;
un support d'émetteur de lumière (210) qui s'étend de l'élément d'émission de lumière (211) et qui supporte l'élément d'émission de lumière (211) ;
un support de récepteur de lumière (220) qui s'étend de l'élément de réception de lumière (221) et qui supporte l'élément de réception de lumière (221) ;
et une partie de connexion (20) qui assure la connexion entre une extrémité du support d'émetteur de lumière (210) et une extrémité du support de récepteur de lumière (221) ;
la partie de connexion (20) comprenant :
un cadre conducteur (24),
une partie de scellement (25) scellant au moins une partie du cadre conducteur (24) ; et
une pluralité de bornes de connexion (26 - 29) comprenant une première borne de connexion (26) qui est connectée au cadre conducteur (24) et qui fait saillie de la partie de scellement (25) ;
**caractérisé en ce que** la première borne de connexion (26) comprend :
une première partie de contact par pression (261) configurée pour établir un contact avec un premier fil (61) qui est pressé dans un sens de contact par pression,
une première partie de pression (260) configurée pour servir à presser la partie de contact par pression (261) dans le sens de contact par pression ; et
une partie de jonction (262) qui assure la connexion entre la première partie de contact par pression (261) et le cadre conducteur (24), la première borne de connexion (26) étant coudée dans le sens de contact par pression au niveau de la partie de jonction (262),
dans lequel le photodétecteur (1) comprend : un dispositif de maintien (3) qui supporte le premier fil (61) ; et
le dispositif de maintien (3) comprend :
un logement de premier fil (311) qui loge le premier fil (61) ; et
un logement de première borne (316) qui loge la première borne de connexion (26) ; dans lequel le premier fil (61) est pressé en contact avec la première borne de connexion (26) à l'intérieur du logement de premier fil (311),
dans lequel la première partie de contact par pression (261) de la première borne de connexion (26) comprend une fente (267),
dans lequel le logement de première borne (316) comprend une saillie (316c) ;
la saillie (316c) fait saillie d'une partie inférieure du logement de première borne (316) en direction de la fente (267) ; et
la partie inférieure du logement de première borne (316) fait face à une extrémité de pointe de la première borne de connexion (26) lorsque le logement de première borne (316) loge la première borne de connexion (26).

2. Photodétecteur (1) selon la revendication 1, dans lequel la première partie de pression (260) de la première borne de connexion (26) est disposée à l'extérieur d'une région de la partie de scellement (25) lorsqu'observée au niveau de la partie de scellement (25) dans le sens de contact par pression.

3. Photodétecteur (1) selon la revendication 1 ou la revendication 2, dans lequel la largeur de la partie de jonction (262) est inférieure à la largeur de la première partie de contact par pression (261).

4. Photodétecteur (1) selon l'une quelconque des revendications 1 à 3, dans lequel la première partie de pression (260) de la première borne de connexion (26) est une partie d'une face de bord de la première borne de connexion (26) telle qu'une épaisseur de feuille de la première borne de connexion (26).

5. Photodétecteur (1) selon l'une quelconque des revendications 1 à 4, comprenant : un premier fil (61) configuré pour être connecté au montage de circuits de capteur (2) ; et
la première partie de contact par pression (261) de la première borne de connexion (26) contacte le premier fil (61) dans le sens de contact par pression.

6. Photodétecteur (1) selon la revendication 5, comprenant : un second fil (62) configuré pour être connecté au montage de circuits de capteur (2) ;
les bornes de la pluralité de bornes de connexion (26 - 29) comprennent une seconde borne de connexion (27) qui fait saillie de la partie de scellement (25) ; et
la seconde borne de connexion (27) est pressée en contact avec le second fil (62) dans le sens de contact par pression.

7. Photodétecteur (1) selon la revendication 6, dans lequel la seconde borne de connexion (27) comprend une seconde partie de contact par pression (271), et une seconde partie de pression (270) configurée pour servir à presser la seconde partie de contact par pression (261) dans le sens de contact par pression.

8. Photodétecteur (1) selon la revendication 6 ou la revendication 7, dans lequel la partie de scellement (25) comprend un premier côté (252) et un second côté (253) ;
les premier et second côtés (252, 253) sont positionnés à l'opposé l'un à l'autre ;
la première borne de connexion (26) et la seconde borne de connexion (27) sont situées sur le premier côté (252) ; et
le second côté (253) ne comporte pas de borne de connexion.

9. Photodétecteur (1) selon l'une quelconque des revendications 6 à 8, comprenant : un dispositif de maintien (3) qui supporte le premier fil (61) et le second fil (62) ;
le dispositif de maintien (3) comprend :
un logement de premier fil (311) qui loge le premier fil (61) ;
un logement de second fil (312) qui loge le second fil (62) ;
un logement de première borne (316) qui loge la première borne de connexion (26) ; et
un logement de seconde borne (317) qui loge la seconde borne de connexion (27) ;
dans lequel
le logement de premier fil (311) et le logement de second fil (312) sont mutuellement partitionnés ;
le premier fil (61) contacte par pression la première borne de connexion (26) à l'intérieur du logement de premier fil (311) ; et
le second fil (62) contacte par pression la seconde borne de connexion (27) à l'intérieur du logement de second fil (312).

10. Photodétecteur (1) selon l'une quelconque des revendications 6 à 9, comprenant : un câble (6) comprenant le premier fil (61), le second fil (62), et un revêtement extérieur (60) qui recouvre le premier fil (61) et le second fil (62) ; et
un dispositif de maintien (3) qui supporte le câble (6) ; dans lequel le dispositif de maintien (3) comprend un trou d'alésage (35) qui le traverse ;
une surface intérieure du trou d'alésage (35) comporte au moins trois saillies (354, 355, 356) ;
le câble (6) traverse le trou d'alésage (35) ; et
un adhésif remplit l'espace entre la surface intérieure du trou d'alésage (35) et le câble (6).

11. Photodétecteur (1) selon la revendication 10, dans lequel le trou d'alésage (35) comprend une première section d'alésage (351) et une seconde section d'alésage (352) ;
la première section d'alésage (351) et la seconde section d'alésage (352) sont situées côte à côte dans la direction axiale du trou d'alésage (35) ;
la seconde section d'alésage (352) comprend une section d'extrémité du trou d'alésage (35) ; et
le diamètre intérieur de la seconde section d'alésage (352) est supérieur au diamètre intérieur de la première section d'alésage (351).

12. Photodétecteur (1) selon l'une quelconque des revendications 10 à 11, dans lequel le dispositif de maintien (3) comprend :
une paroi (31) qui chevauche une partie du trou d'alésage (35), la paroi (31) comprenant un logement de premier fil (311) qui loge le premier fil (61) ; et un logement de second fil (312) qui loge le second fil (62) ; et
une section de positionnement (36) constituée par une partie de la paroi (31) qui chevauche une partie du trou d'alésage (35) dans la direction dans laquelle le trou d'alésage traverse le dispositif de maintien (3).

13. Photodétecteur (1) selon l'une quelconque des revendications 1 à 12, dans lequel le montage de circuits de capteur (2) comprend une partie lentille d'émetteur de lumière (312) qui couvre l'élément d'émission de lumière (211), et une partie lentille de récepteur de lumière (222) qui couvre l'élément de réception de lumière (221) ; et
la partie lentille de récepteur de lumière (222) et la partie lentille d'émetteur de lumière (212) ont des formes différentes.

14. Photodétecteur (1) selon l'une quelconque des revendications 5 à 13, comprenant : un câble (6) comprenant le premier fil (61) ;
un dispositif de maintien (3) qui supporte le montage de circuits de capteur (2) et le câble (6) ;
et un boîtier principal (5) comportant un espace interne doté d'une ouverture qui enferme le montage de circuits de capteur (2) et le dispositif de maintien (3) ; dans lequel
le dispositif de maintien (3) comprend un trou d'alésage (35) dans un sens de contact par pression vers le bas ;
le câble (6) traverse le trou d'alésage (35) ; et
le dispositif de maintien (3) comprend un logement de premier fil (311) qui loge le premier fil (61) ; et un logement de première borne (316) qui loge la première borne de connexion (26) ; dans lequel
le logement de premier fil (311) a un axe longitudinal s'étendant dans une direction qui coupe le sens de contact par pression vers le bas, et débouche vers le haut ;
le logement de première borne (316) coupe le logement de premier fil (311) et débouche vers le haut ;
le montage de circuits de capteur (2) est monté sur la partie supérieure du dispositif de maintien (3) ; et
une extrémité de pointe de la première borne de connexion (26) fait face vers le bas ;
la première partie de contact par pression (261) de la première borne de connexion (26) perce le premier fil (61) à partir du dessus dans le logement de premier fil (311) et est par conséquent pressée en contact avec le premier fil (61) ;
l'espace interne débouchant dans le boîtier principal (5) fait face vers le bas ; et
le boîtier principal (5) est monté sur la partie supérieure du dispositif de maintien (3).

15. Photodétecteur (1) selon l'une quelconque des revendications 1 à 14, comprenant : un dispositif de maintien (3) qui supporte le montage de circuits de capteur (2) ;
et un boîtier principal (5) qui loge le montage de circuits de capteur (2) et le dispositif de maintien (3) ; dans lequel
le boîtier principal (5) comprend :
un boîtier d'émetteur de lumière (53) qui loge l'élément d'émission de lumière (211) ;
un boîtier de récepteur de lumière (54) qui loge l'élément de réception de lumière (221) ; et
une rainure de détection (55) située entre le boîtier d'émetteur de lumière (53) et le boîtier de récepteur de lumière (54) ; et
le boîtier principal (5) comprend un repère (533, 543) ; dans lequel
le repère (533, 543) indique une profondeur de détection nécessaire pour un objet à détecter dans la rainure de détection (55).

16. Photodétecteur (1) selon l'une quelconque des revendications 6 à 15, comprenant : un câble (6) comprenant le premier fil (61) et le second fil (62) ;
un dispositif de maintien (3) qui supporte le montage de circuits de capteur (2) et le câble (6) ;
et un boîtier principal (5) qui comprend un espace interne doté d'une ouverture qui loge le montage de circuits de capteur (2) et le dispositif de maintien (3) ; dans lequel
le dispositif de maintien (3) comprend un trou d'alésage (35) dans un sens de contact par pression vers le bas ; et
le câble (6) traverse le trou d'alésage (35) ; et
le dispositif de maintien (3) comprend :
un logement de premier fil (311) qui loge le premier fil (61) ;
un logement de second fil (312) qui loge le second fil (62) ;
un logement de première borne (316) qui loge la première borne de connexion (26) ; et
un logement de seconde borne (317) qui loge la seconde borne de connexion (27) ; dans lequel
le logement de premier fil (311) et le logement de second fil (312) s'étendent dans une direction qui coupe le sens de contact par pression vers le bas, et débouchent vers le haut ; et
le logement de première borne (316) coupe le logement de premier fil (311) et débouche vers le haut ; et
le logement de seconde borne (317) coupe le logement de second fil (312) et débouche vers le haut ; et
une extrémité de pointe de la première borne de connexion (26) et une extrémité de pointe de la seconde borne de connexion (27) font face vers le bas ; et
la première borne de connexion (26) est pressée en contact avec le premier fil (61) à l'intérieur du logement de premier fil (311) ; et
la seconde borne de connexion (27) est pressée en contact avec le second fil à l'intérieur du logement de second fil (312).
